# EUROPEAN PATENT APPLICATION

(11) **EP 4 447 120 A1**
(43) Date of publication of application: **16.10.2024**
(21) Application number: 23216361.8
(22) Date of filing: 13.12.2023
(51) Int. Cl.: H01L 29/06, H01L 29/423, H01L 29/66, H01L 29/775

(54) **SEMICONDUCTOR DEVICE AND METHOD OF FABRICATING THE SAME**

(30) Priority: 11.04.2023 KR 20230047429
(71) Applicant: Samsung Electronics Co., Ltd., Suwon-si, Gyeonggi-do 16677 (KR)
(72) Inventor: PARK, Junmo, 16677 Suwon-si (KR); KIM, Deokhwan, 16677 Suwon-si (KR); KONG, Junsu, 16677 Suwon-si (KR); PARK, Yeonho, 16677 Suwon-si (KR); PARK, Hyungjin, 16677 Suwon-si (KR); LEE, Sujin, 16677 Suwon-si (KR); LEE, Jinseok, 16677 Suwon-si (KR)
(74) Representative: Marks & Clerk LLP

(57) **Abstract**

A semiconductor device including a substrate having an active pattern (AP1), first and second semiconductor patterns (SP1, SP2) provided on the active pattern vertically spaced apart from each other, a source/drain pattern (SD1) connected to the first and second semiconductor patterns, a gate electrode (GE; PO2) between the first and second semiconductor patterns, and a gate insulating pattern (GI) enclosing the gate electrode, wherein the gate insulating pattern (GI) includes, a high-k dielectric pattern (HK) enclosing the gate electrode, an inner spacer (IS) between the high-k dielectric pattern and the source/drain pattern, and a mask insulating pattern (MI) having an etch selectivity with respect to the inner spacer between the high-k dielectric pattern and the inner spacer.

## Description

### BACKGROUND

### 1. Field

The present disclosure relates to semiconductor devices and methods of fabricating the same.

### 2. Description of the Related Art

A semiconductor device includes an integrated circuit composed of metal-oxide-semiconductor field-effect transistors (MOS-FETs). To meet an increasing demand for a semiconductor device with a small pattern size and a reduced design rule, the MOS-FETs are being aggressively scaled down. The scale-down of the MOS-FETs may lead to deterioration in operational properties of the semiconductor device. A variety of studies are being conducted to overcome technical limitations associated with the scale-down of the semiconductor device and to realize high-performance semiconductor devices.

### SUMMARY

The embodiments may be realized by providing a substrate having an active pattern, first and second semiconductor patterns provided on the active pattern vertically spaced apart from each other, a source/drain pattern connected to the first and second semiconductor patterns, a gate electrode between the first and second semiconductor patterns, and a gate insulating pattern enclosing the gate electrode,
wherein the gate insulating pattern includes, a high-k dielectric pattern enclosing the gate electrode, an inner spacer between the high-k dielectric pattern and the source/drain pattern, and a mask insulating pattern having an etch selectivity with respect to the inner spacer between the high-k dielectric pattern and the inner spacer.

The embodiments may be realized by providing a semiconductor device including a substrate having an active pattern, first and second semiconductor patterns provided on the active pattern to be vertically spaced apart from each other, a source/drain pattern connected to the first and second semiconductor patterns, a gate electrode between the first and second semiconductor patterns, and a gate insulating pattern enclosing the gate electrode, wherein the gate insulating pattern includes a high-k dielectric pattern enclosing the gate electrode, an inner spacer between the high-k dielectric pattern and the source/drain pattern, and a mask insulating pattern spaced apart from the first semiconductor pattern and between the high-k dielectric pattern and the inner spacer.

The embodiments may be realized by providing a semiconductor device, including a substrate including an active pattern, a plurality of semiconductor patterns stacked on the active pattern to be vertically spaced apart from each other, a source/drain pattern connected to the semiconductor patterns, a gate electrode between first and second semiconductor patterns of the semiconductor patterns, and a gate insulating pattern enclosing the gate electrode, wherein the gate insulating pattern includes a high-k dielectric pattern enclosing the gate electrode an inner spacer between the high-k dielectric pattern and the source/drain pattern a mask insulating pattern between the high-k dielectric pattern and the inner spacer, and a horizontal insulating pattern between the high-k dielectric pattern and the first semiconductor pattern and extending to a region between the first semiconductor pattern and the inner spacer.

The embodiments may be realized by providing a method of fabricating a semiconductor device, including forming a stacking pattern including active layers and sacrificial layers, which are alternately stacked on top of each other, forming a sacrificial pattern on the stacking pattern, etching the stacking pattern and the active layers using the sacrificial pattern as a mask to form a pair of recesses at both sides of the sacrificial pattern and form a first semiconductor pattern and a second semiconductor pattern, which are vertically spaced apart from each other, from a remaining portion of the active layers, forming a pair of source/drain patterns in the pair of recesses, removing the sacrificial pattern and the sacrificial layers to expose the first and second semiconductor patterns, and sequentially forming a gate insulating pattern and a gate electrode on the exposed surfaces of the first and second semiconductor patterns, wherein an inner region is defined between the pair of source/drain patterns and between the first and second semiconductor patterns, wherein the forming of the gate insulating pattern includes forming an inner spacer layer to cover an inner side surface of the inner region, forming a mask insulating layer in the inner region to cover the inner spacer layer, and etching the inner spacer layer using the mask insulating layer as an etch mask to form an inner spacer and form a mask insulating pattern from a remaining portion of the mask insulating layer.

At least some of the above and other features of the invention are set out in the claims.

### BRIEF DESCRIPTION OF THE DRAWINGS

Features will become apparent to those of skill in the art by describing in detail embodiments with reference to the attached drawings in which:
FIGS. 1 to 3 show conceptual diagrams of logic cells of a semiconductor device according to an embodiment;
FIG. 4 shows a plan view of a semiconductor device according to an embodiment;
FIGS. 5A to 5D show sectional views, which are respectively taken along lines A-A', B-B', C-C', and D-D' of FIG. 4;
FIGS. 6A, 7A, and 8A show enlarged sectional views of a portion 'M1' of FIG. 5A;
FIGS. 6B, 7B, and 8B show enlarged sectional views of respective portions 'M2' of FIGS. 6A, 7A, and 8A;
FIGS. 9A, 9B, 10A, 10B, 11A, 11B, 11C, 12A, 12B, 12C, 13A, 13B, and 13C show sectional views of stages in a method of fabricating a semiconductor device, according to an embodiment;
FIGS. 14A, 14B, 15A, 15B, 16A, and 16B show enlarged sectional views of a portion 'M1' of FIG. 13A and stages in a method of fabricating the semiconductor device of FIGS. 6A and 6B;
FIGS. 17A, 17B, 18A, and 18B show enlarged sectional views of a portion `M1' of FIG. 13A and stages in a method of fabricating the semiconductor device of FIGS. 7A and 7B; and
FIGS. 19A, 19B, 20A, and 20B are enlarged sectional views of a portion `M1' of FIG. 13A and stages in a method of fabricating the semiconductor device of FIGS. 8A and 8B.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the invention to those skilled in the art.

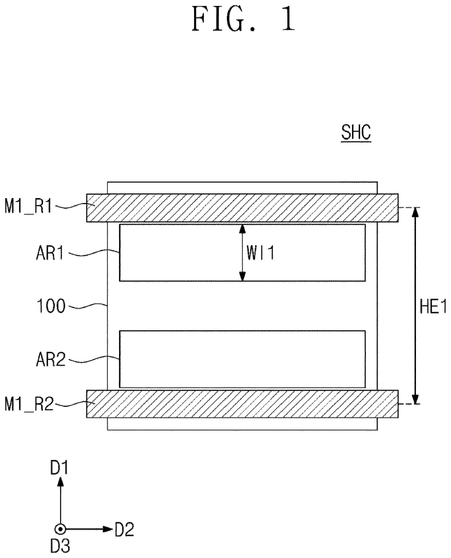

FIGS. 1 to 3 show conceptual diagrams of logic cells of a semiconductor device according to an embodiment.

Referring to FIG. 1, a single height cell SHC may be provided. In detail, a first power line M1_R1 and a second power line M1_R2 may be on a substrate 100. The first power line M1_R1 may be a conduction path, to which a source voltage (VSS), e.g., a ground voltage, is provided. The second power line M1_R2 may be a conduction path, to which a drain voltage (VDD), e.g., a power voltage, is provided.

The single height cell SHC may be defined between the first power line M1_R1 and the second power line M1_R2. The single height cell SHC includes a first active region AR1 and a second active region AR2. One of either the first or second active regions AR1 and AR2 may be a PMOSFET region, and the other may be an NMOSFET region. In other words, the single height cell SHC may have a CMOS structure between the first and second power lines M1_R1 and M1_R2.

Each of the first and second active regions AR1 and AR2 has a first width WI1 in a first direction D1. A length of the single height cell SHC in the first direction D1 may be defined as a first height HE1. The first height HE1 may be substantially equal to a distance (e.g., a pitch) between the first and second power lines M1_R1 and M1_R2.

The single height cell SHC may constitute a single logic cell. In the present specification, a logic cell may mean a logic device (e.g., AND, OR, XOR, XNOR, inverter, and so forth), which is configured to execute a specific function. In other words, the logic cell may include transistors constituting the logic device and interconnection lines connecting transistors to each other.

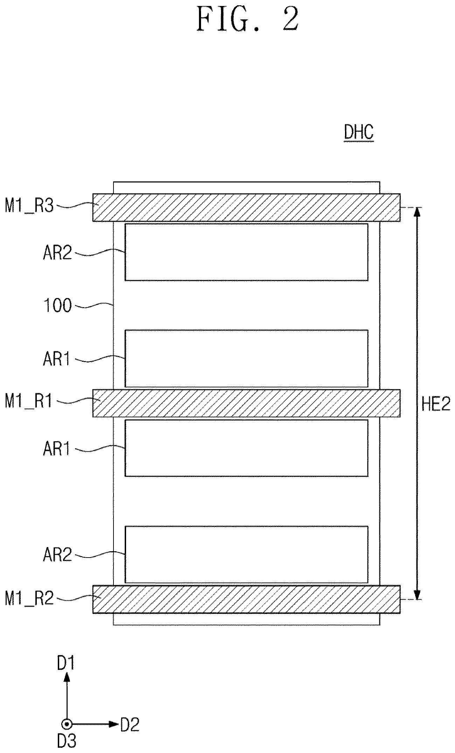

Referring to FIG. 2, a double height cell DHC may be provided. In detail, a first power line M1_R1, a second power line M1_R2, and a third power line M1_R3 may be on the substrate 100. The first power line M1_R1 may be between the second power line M1_R2 and the third power line M1_R3. The third power line M1_R3 may be a conduction path, to which the source voltage (VSS) is provided.

The double height cell DHC may be defined between the second power line M1_R2 and the third power line M1_R3. The double height cell DHC includes a pair of first active regions AR1 and a pair of second active regions AR2.

One of the second active regions AR2 may be adjacent to the second power line M1_R2. The other of the second active regions AR2 may be adjacent to the third power line M1_R3. The pair of first active regions AR1 may be adjacent to the first power line M1_R1. When viewed in a plan view, the first power line M1_R1 may be between the pair of the first active regions AR1.

A length of the double height cell DHC in the first direction D1 may be defined as a second height HE2. The second height HE2 may be about two times the first height HE1 of FIG. 1. The pair of the first active regions AR1 of the double height cell DHC may be combined to serve as a single active region.

In an embodiment, the double height cell DHC shown in FIG. 2 may be defined as a multi-height cell. Although not shown, the multi-height cell may include a triple height cell whose cell height is about three times that of the single height cell SHC.

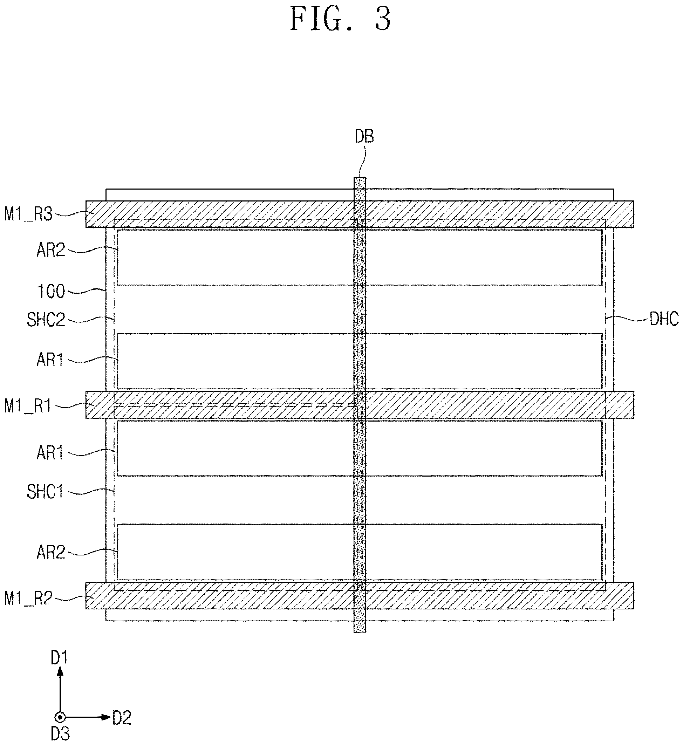

Referring to FIG. 3, a first single height cell SHC1, a second single height cell SHC2, and a double height cell DHC may be two-dimensionally arranged on the substrate 100. The first single height cell SHC1 may be between the first and second power lines M1_R1 and M1_R2. The second single height cell SHC2 may be between the first and third power lines M1_R1 and M1_R3. The second single height cell SHC2 may be adjacent to the first single height cell SHC1 in the first direction D1.

The double height cell DHC may be between the second and third power lines M1_R2 and M1_R3. The double height cell DHC may be adjacent to the first and second single height cells SHC1 and SHC2 in a second direction D2.

A division structure DB may be between the first single height cell SHC1 and the double height cell DHC and between the second single height cell SHC2 and the double height cell DHC. The active region of the double height cell DHC may be electrically separated from the active region of each of the first and second single height cells SHC1 and SHC2 by the division structure DB.

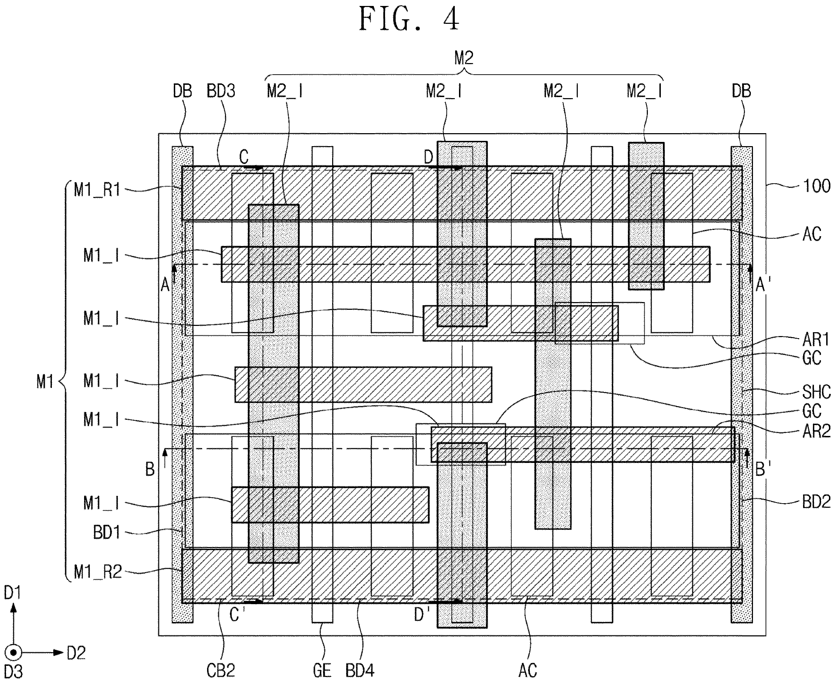

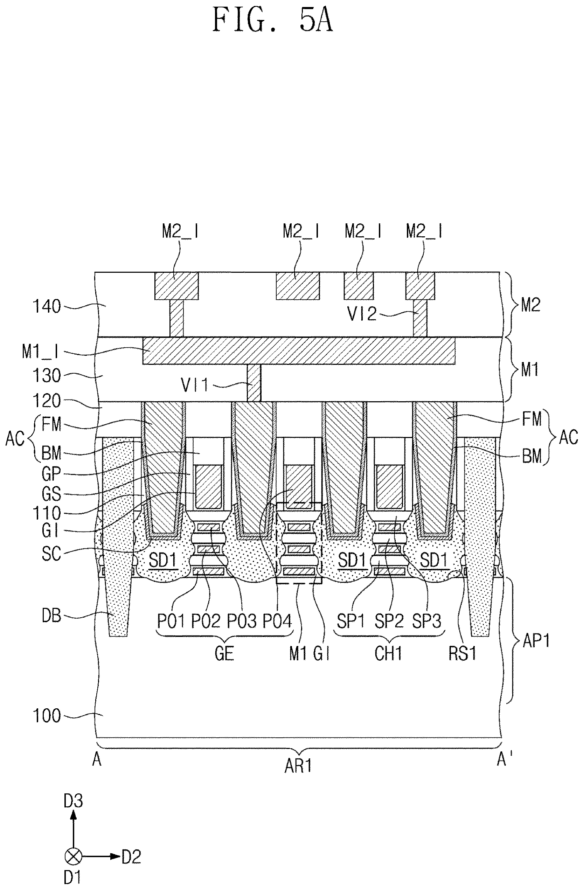

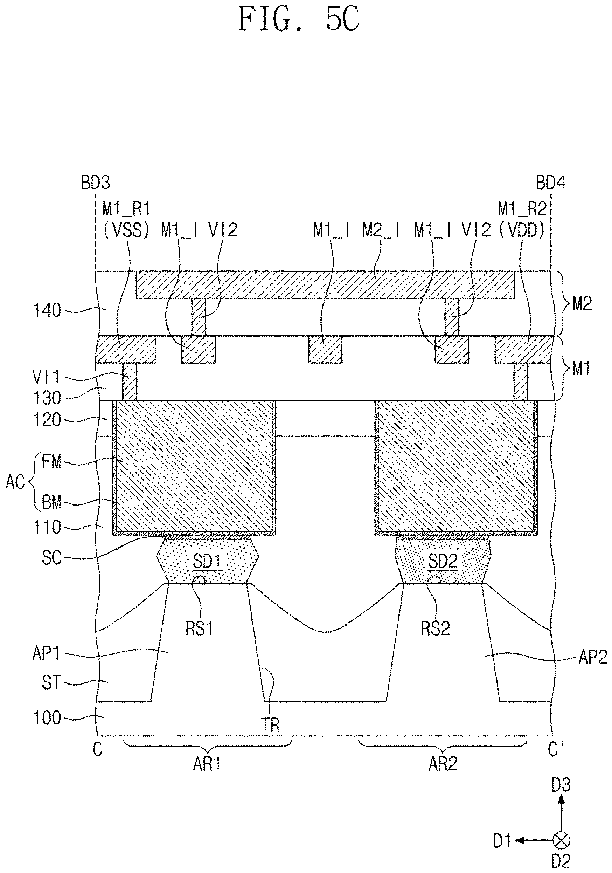

FIG. 4 shows a plan view of a semiconductor device according to an embodiment. FIGS. 5A to 5D show sectional views, which are respectively taken along lines A-A', B-B', C-C', and D-D' of FIG. 4.

The semiconductor device of FIGS. 4 and 5A to 5D may be a concrete example of the single height cell SHC of FIG. 1. Referring to FIGS. 4 to 5D, the single height cell SHC may be on the substrate 100. Logic transistors constituting a logic circuit may be on the single height cell SHC. The substrate 100 may be a semiconductor substrate that is formed of or includes, e.g., silicon, germanium, silicon germanium, a compound semiconductor material, or the like. In an embodiment, the substrate 100 may be a silicon wafer. As used herein, the term "or" is not an exclusive term, e.g., "A or B" would include A, B, or A and B."

The substrate 100 may include the first active region AR1 and the second active region AR2. Each of the first and second active regions AR1 and AR2 may be extended in the second direction D2. The first active region AR1 may be a NMOSFET or a PMOSFET region, and the second active region AR2 may be the other NMOSFET or PMOSFET region. In an embodiment, the first active region AR1 may be an NMOSFET region, and the second active region AR2 may be a PMOSFET region.

A first active pattern AP1 and a second active pattern AP2 may be defined by a trench TR, which is formed in an upper portion of the substrate 100. The first active pattern AP1 may be on the first active region AR1, and the second active pattern AP2 may be on the second active region AR2. The first and second active patterns AP1 and AP2 may be extended in the second direction D2. Each of the first and second active patterns AP1 and AP2 may be a vertically-protruding portion of the substrate 100, i.e., the first and second active patters AP1 and AP2 may protrude in a third direction D3.

A device isolation layer ST may be on the substrate 100. The device isolation layer ST may fill the trench TR. The device isolation layer ST may be formed of or include silicon oxide. The device isolation layer ST may not cover first and second channel patterns CH1 and CH2 to be described below.

A first channel pattern CH1 may be on the first active pattern AP1. A second channel pattern CH2 may be on the second active pattern AP2. Each of the first and second channel patterns CH1 and CH2 may include a first semiconductor pattern SP1, a second semiconductor pattern SP2, and a third semiconductor pattern SP3, which are sequentially stacked. The first to third semiconductor patterns SP1, SP2, and SP3 are spaced apart from each other in a vertical direction, i.e., the third direction D3.

Each of the first to third semiconductor patterns SP1, SP2, and SP3 may be formed of or include, e.g., silicon (Si), germanium (Ge), or silicon germanium (SiGe). In an implementation, each of the first to third semiconductor patterns SP1, SP2, and SP3 may be formed of or include crystalline silicon.

A plurality of first source/drain patterns SD1 may be on the first active pattern AP1. A plurality of first recesses RS1 may be formed in an upper portion of the first active pattern AP1. The first source/drain patterns SD1 may be provided in the first recesses RS1, respectively. The first source/drain patterns SD1 may be impurity regions of a first conductivity type. The first channel pattern CH1 may be between each pair of the first source/drain patterns SD1. In other words, each pair of the first source/drain patterns SD1 may be connected to each other by the stacked first to third semiconductor patterns SP1, SP2, and SP3.

A plurality of second source/drain patterns SD2 may be on the second active pattern AP2. A plurality of second recesses RS2 may be formed in an upper portion of the second active pattern AP2. The second source/drain patterns SD2 may be in the second recesses RS2, respectively. The second source/drain patterns SD2 may be impurity regions of a second conductivity type. The second channel pattern CH2 may be between each pair of the second source/drain patterns SD2. In other words, each pair of the second source/drain patterns SD2 may be connected to each other by the stacked first to third semiconductor patterns SP1, SP2, and SP3.

The first conductivity type of the first source/drain pattern SD1 may be n-type or p-type, and the second conductivity type of the second source/drain pattern SD2 may be the other of the n-type or p-type. In an embodiment, the first conductivity type may be the n-type, and the second conductivity type may be the p-type.

The first and second source/drain patterns SD1 and SD2 may be epitaxial patterns, which are formed by a selective epitaxial growth (SEG) process. In an embodiment, each of the first and second source/drain patterns SD1 and SD2 may have a top surface that is higher than a top surface of the third semiconductor pattern SP3. In another embodiment, a top surface of at least one of the first and second source/drain patterns SD1 and SD2 may be located at substantially the same level as the top surface of the third semiconductor pattern SP3.

In an embodiment, the first source/drain patterns SD1 may be formed of or include the same semiconductor element, e.g., Si, as the substrate 100. The second source/drain patterns SD2 may include a semiconductor material, e.g., SiGe, whose lattice constant is greater than that of the substrate 100. In this case, the pair of the second source/drain patterns SD2 may exert a compressive stress on the second channel pattern CH2 therebetween.

A side surface of each of the first and second source/drain patterns SD1 and SD2 may have an uneven or embossing shape. In other words, the side surface of each of the first and second source/drain patterns SD1 and SD2 may have a wavy profile. The side surface of each of the first and second source/drain patterns SD1 and SD2 may protrude toward first to third inner electrodes PO1, PO2, and PO3 of a gate electrode GE, which will be described below.

Gate electrodes GE may be provided to cross the first and second channel patterns CH1 and CH2 and to extend in the first direction D1. The gate electrodes GE may be arranged at a first pitch in the second direction D2. Each of the gate electrodes GE may vertically overlap with the first and second channel patterns CH1 and CH2.

The gate electrode GE may include a first inner electrode PO1 between the active pattern AP1 or AP2 and the first semiconductor pattern SP1, a second inner electrode PO2 between the first semiconductor pattern SP1 and the second semiconductor pattern SP2, a third inner electrode PO3 between the second semiconductor pattern SP2 and the third semiconductor pattern SP3, and an outer electrode PO4 on the third semiconductor pattern SP3.

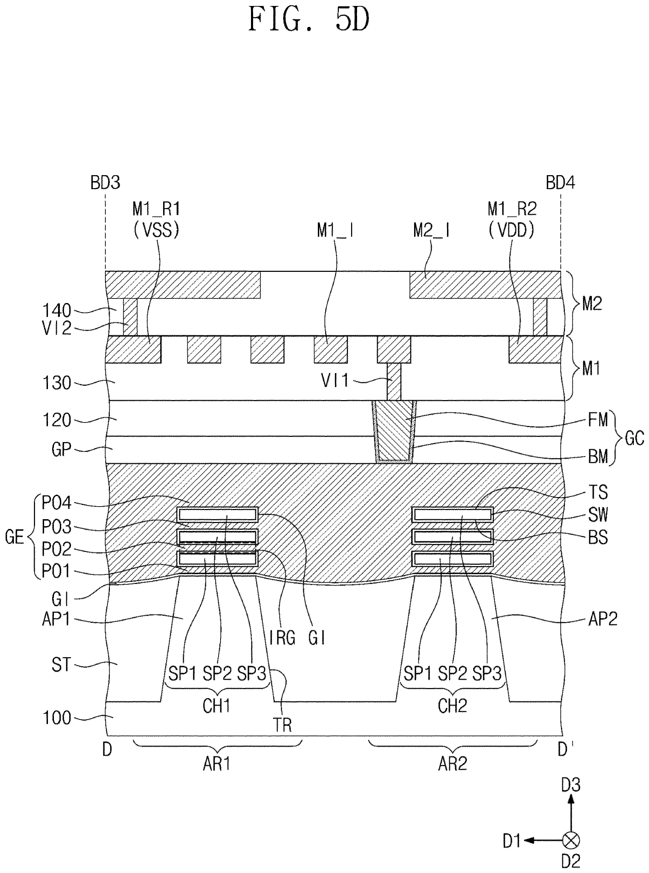

Referring to FIG. 5D, the gate electrode GE may be on a top surface TS, a bottom surface BS, and opposite side surfaces SW of each of the first to third semiconductor patterns SP1, SP2, and SP3. That is, the transistor according to the present embodiment may be a three-dimensional field effect transistor, e.g., MBCFET or GAAFET, in which the gate electrode GE is provided to three-dimensionally surround the channel pattern.

Referring back to FIGS. 4 and 5A to 5D, a pair of gate spacers GS may be respectively on opposite side surfaces of the outer electrode PO4 of the gate electrode GE. The gate spacers GS may be extended along the gate electrode GE and in the first direction D1. Top surfaces of the gate spacers GS may be higher than a top surface of the gate electrode GE. In an embodiment, the gate spacers GS may be formed of or include, e.g., silicon carbon nitride (SiCN), silicon carbon oxynitride (SiCON), or silicon nitride (SiN). In other embodiments, the gate spacers GS have a multi-layered structure, which includes, e.g., two different materials selected from silicon carbon nitride (SiCN), silicon carbon oxynitride (SiCON), and silicon nitride (SiN).

A gate capping pattern GP may be on the gate electrode GE. The gate capping pattern GP may be extended along the gate electrode GE and in the first direction D1. The gate capping pattern GP may be formed of or include a material having an etch selectivity with respect to first and second interlayer insulating layers 110 and 120, which will be described below. In detail, the gate capping pattern GP may be formed of or include, e.g., silicon oxynitride (SiON), silicon carbon nitride (SiCN), silicon carbon oxynitride (SiCON), or silicon nitride (SiN).

A gate insulating pattern GI may be between the gate electrode GE and the first channel pattern CH1 and between the gate electrode GE and the second channel pattern CH2. The gate insulating pattern GI may directly cover the top surface TS, the bottom surface BS, and the opposite side surfaces SW of each of the first to third semiconductor patterns SP1, SP2, and SP3. The gate insulating pattern GI may cover a top surface of the device isolation layer ST below the gate electrode GE.

The gate electrode GE may include a first metal pattern and a second metal pattern on the first metal pattern. The first metal pattern may be on the gate insulating pattern GI and may be adjacent to the first to third semiconductor patterns SP1, SP2, and SP3. The first metal pattern may include a work-function metal, which can be used to adjust a threshold voltage of the transistor. By adjusting a thickness and composition of the first metal pattern, it may be possible to realize a transistor having a desired threshold voltage. In an implementation, the first to third inner electrodes PO1, PO2, and PO3 of the gate electrode GE may be composed of the first metal pattern or the work-function metal.

The first metal pattern may be formed of or include, e.g., metal nitride materials. In an embodiment, the first metal pattern may include a layer that is composed, e.g., metallic material, which is selected from the group consisting of titanium (Ti), tantalum (Ta), aluminum (Al), tungsten (W) and molybdenum (Mo), and nitrogen (N). In an embodiment, the first metal pattern may further include carbon (C). The first metal pattern may include a plurality of work function metal layers which are stacked.

The second metal pattern may be formed of or include a metallic material whose resistance is lower than the first metal pattern. In an implementation, the second metal pattern may be formed of or include a metallic material, which is selected from the group consisting of tungsten (W), aluminum (Al), titanium (Ti), and tantalum (Ta). The fourth outer electrode PO4 of the gate electrode GE may include the first metal pattern and the second metal pattern on the first metal pattern.

A first interlayer insulating layer 110 may be on the substrate 100. The first interlayer insulating layer 110 may cover the gate spacers GS and the first and second source/drain patterns SD1 and SD2. The first interlayer insulating layer 110 may have a top surface that is substantially coplanar with the top surface of the gate capping pattern GP and the top surface of the gate spacer GS. A second interlayer insulating layer 120 may be formed on the first interlayer insulating layer 110 to cover the gate capping pattern GP. A third interlayer insulating layer 130 may be on the second interlayer insulating layer 120. A fourth interlayer insulating layer 140 may be on the third interlayer insulating layer 130. In an embodiment, at least one of the first to fourth interlayer insulating layers 110, 120, 130, and 140 may include a silicon oxide layer.

The single height cell SHC may have a first border BD1 and a second border BD2, which are opposite to each other in the second direction D2. The first and second borders BD1 and BD2 may be extended in the first direction D1. The single height cell SHC may have a third border BD3 and a fourth border BD4, which are opposite to each other in the first direction D1. The third and fourth borders BD3 and BD4 may be extended in the second direction D2.

A pair of division structures DB, which are opposite to each other in the second direction D2, may be at both sides of the single height cell SHC. In an implementation, the pair of the division structures DB may be respectively on the first and second borders BD1 and BD2 of the single height cell SHC. The division structure DB may be extended in the first direction D1 to be parallel to the gate electrodes GE. A pitch between the division structure DB and the gate electrode GE adjacent thereto may be equal to the first pitch.

The division structure DB may penetrate the gate capping pattern GP and the gate electrode GE and may extend into the first and second active patterns AP1 and AP2. The division structure DB may penetrate an upper portion of each of the first and second active patterns AP1 and AP2. The division structure DB may electrically separate an active region of each of the single height cell SHC from an active region of a neighboring cell.

Active contacts AC may penetrate the first and second interlayer insulating layers 110 and 120 and be electrically connected to the first and second source/drain patterns SD1 and SD2, respectively. A pair of the active contacts AC may be respectively at both sides of the gate electrode GE. When viewed in a plan view, the active contact AC may be a bar-shaped pattern that extends in the first direction D1.

The active contact AC may be a self-aligned contact. In an implementation, the active contact AC may be formed by a self-alignment process using the gate capping pattern GP and the gate spacer GS. In an implementation, the active contact AC may cover at least a portion of the side surface of the gate spacer GS. Although not shown, the active contact AC may cover a portion of the top surface of the gate capping pattern GP.

Metal-semiconductor compound layers SC, e.g., silicide layers, may be respectively between the active contact AC and the first source/drain pattern SD1 and between the active contact AC and the second source/drain pattern SD2. The active contact AC may be electrically connected to the source/drain pattern SD1 or SD2 through the metal-semiconductor compound layer SC. In an implementation, the metal-semiconductor compound layer SC may be formed of or include, e.g., titanium silicide, tantalum silicide, tungsten silicide, nickel silicide, or cobalt silicide.

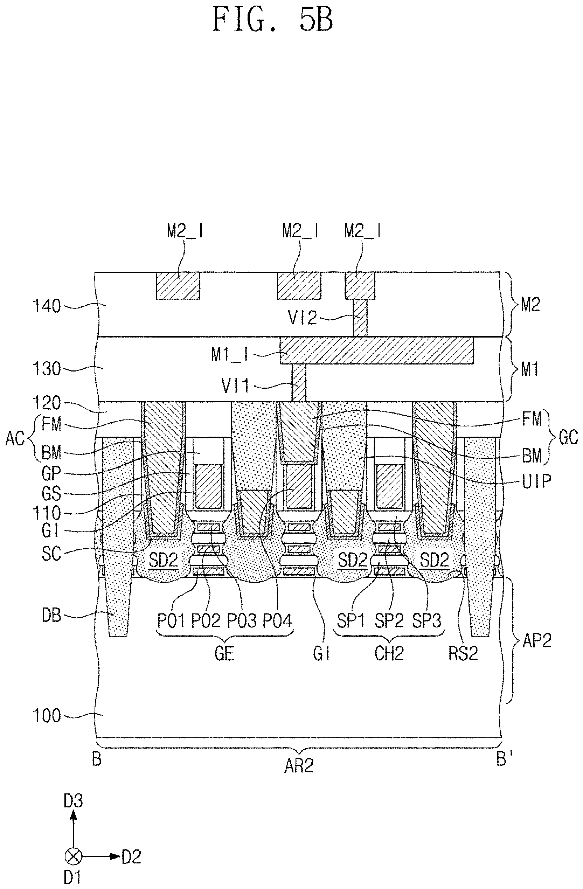

Gate contacts GC may penetrate the second interlayer insulating layer 120 and the gate capping pattern GP and be electrically connected to the gate electrodes GE, respectively. When viewed in a plan view, the gate contacts GC may respectively overlap with the first and second active regions AR1 and AR2. In an implementation, the gate contact GC may be on the second active pattern AP2 (e.g., see FIG. 5B).

In an embodiment, referring to FIG. 5B, an upper portion of the active contact AC adjacent to the gate contact GC may be filled with an upper insulating pattern UIP. A bottom surface of the upper insulating pattern UIP may be lower than a bottom surface of the gate contact GC. In an implementation, a top surface of the active contact AC adjacent to the gate contact GC may be formed at a level, which is lower than the bottom surface of the gate contact GC, by the upper insulating pattern UIP. Accordingly, it may be possible to prevent the gate contact GC and the active contact AC, which are adjacent to each other, from being in contact with each other and thereby to prevent a short circuit issue from occurring therebetween.

Each of the active and gate contacts AC and GC may include a conductive pattern FM and a barrier pattern BM enclosing the conductive pattern FM. In an implementation, the conductive pattern FM may be formed of or include metallic materials, e.g., aluminum, copper, tungsten, molybdenum, or cobalt. The barrier pattern BM may be provided to cover side and bottom surfaces of the conductive pattern FM. In an embodiment, the barrier pattern BM may include a metal layer and a metal nitride layer. The metal layer may be formed of or include, e.g., titanium, tantalum, tungsten, nickel, cobalt, or platinum. The metal nitride layer may be formed of or include, e.g., titanium nitride (TiN), tantalum nitride (TaN), tungsten nitride (WN), nickel nitride (NiN), cobalt nitride (CoN), or platinum nitride (PtN).

A first metal layer M1 may be in the third interlayer insulating layer 130. In an implementation, the first metal layer M1 may include the first power line M1_R1, the second power line M1_R2, and first interconnection lines M1_I. Each of the interconnection lines M1_R1, M1_R2, and M1_I of the first metal layer M1 may extend in the second direction D2 and parallel to each other.

In an implementation, the first and second power lines M1_R1 and M1_R2 may be respectively on the third and fourth borders BD3 and BD4 of the single height cell SHC. The first power line M1_R1 may be extended along the third border BD3 and in the second direction D2. The second power line M1_R2 may be extended along the fourth border BD4 and in the second direction D2.

The first interconnection lines M1_I of the first metal layer M1 may be between the first and second power lines M1_R1 and M1_R2. The first interconnection lines M1_I of the first metal layer M1 may be arranged at a second pitch in the first direction D1. The second pitch may be smaller than the first pitch. A linewidth of each of the first interconnection lines M1_I may be smaller than a linewidth of each of the first and second power lines M1_R1 and M1_R2.

The first metal layer M1 may further include first vias VI1. The first vias VI1 may be respectively below the interconnection lines M1_R1, M1_R2, and M1_I of the first metal layer M1. The active contact AC and the interconnection line of the first metal layer M1 may be electrically connected to each other through the first via VI1. The gate contact GC and the interconnection line of the first metal layer M1 may be electrically connected to each other through the first via VI1.

The interconnection line of the first metal layer M1 and the first via VI1 thereunder may be formed by separate processes. In an implementation, the interconnection line and the first via VI1 of the first metal layer M1 may be independently formed by respective single damascene processes. The semiconductor device according to the present embodiment may be fabricated using a sub-20 nm process.

A second metal layer M2 may be in the fourth interlayer insulating layer 140. The second metal layer M2 may include a plurality of second interconnection lines M2_I. Each of the second interconnection lines M2_I of the second metal layer M2 may be a line- or bar-shaped pattern that is extended in the first direction D1. In other words, the second interconnection lines M2_I may extend in the first direction D1 and parallel to each other.

The second metal layer M2 may further include second vias VI2, which are respectively below the second interconnection lines M2_I. The interconnection lines of the first and second metal layers M1 and M2 may be electrically connected to each other through the second via VI2. The interconnection line of the second metal layer M2 and the second via VI2 thereunder may be formed together by a dual damascene process.

The interconnection lines of the first metal layer M1 may be formed of or include a conductive material that is the same as or different from those of the second metal layer M2. In an implementation, the interconnection lines of the first and second metal layers M1 and M2 may be formed of or include metallic materials e.g., aluminum, copper, tungsten, ruthenium, molybdenum, or cobalt. In an implementation, a plurality of metal layers, e.g., M3, M4, M5, and so forth, may be additionally stacked on the fourth interlayer insulating layer 140. Each of the stacked metal layers may include interconnection lines, which are used as routing paths between cells.

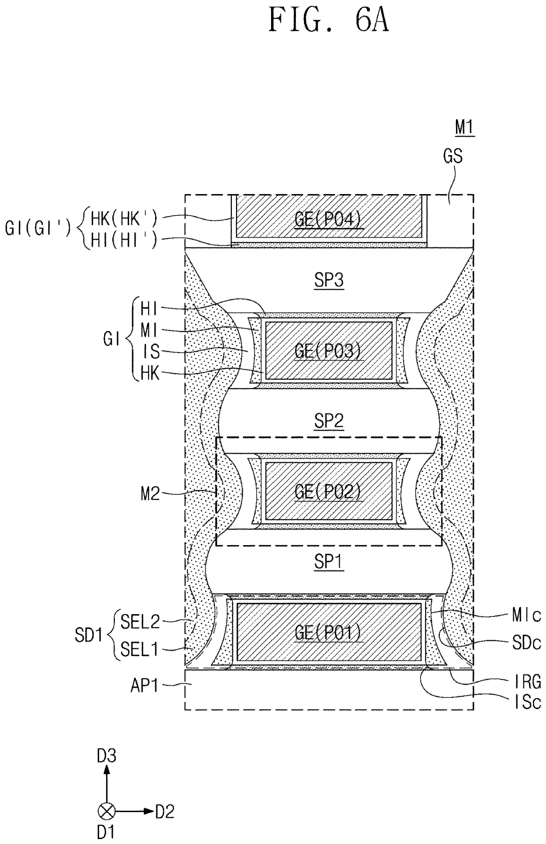

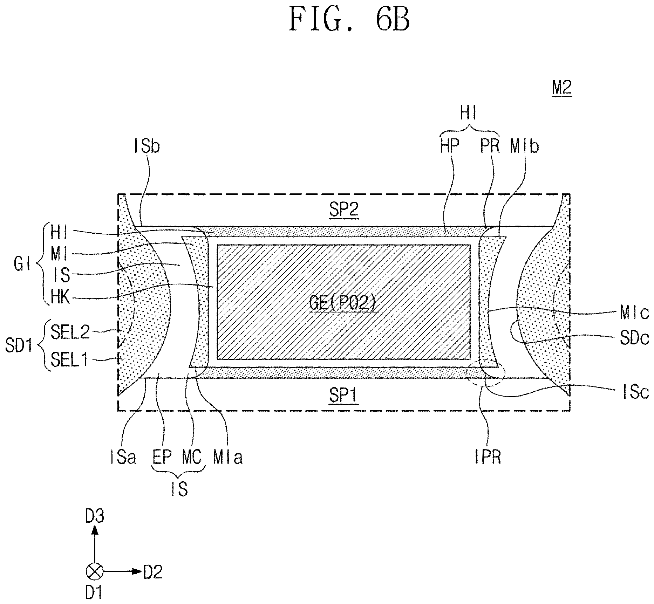

FIGS. 6A, 7A, and 8A show enlarged sectional views of a portion `M1' of FIG. 5A. FIGS. 6B, 7B, and 8B show enlarged sectional views of respective portions 'M2' of FIGS. 6A, 7A, and 8A. Hereinafter, the gate insulating pattern GI according to an embodiment will be described in more detail with reference to FIGS. 6A to 8B. For concise description, a previously described element may be identified by the same reference number without repeating an overlapping description thereof.

Referring to FIGS. 6A to 8B, inner regions IRG may be defined between a pair of the first source/drain patterns SD1 and between the first to third semiconductor patterns SP1, SP2, and SP3. The gate electrode GE may be in the inner regions IRG. The gate insulating pattern GI may be in the inner regions IRG to enclose the gate electrode GE. The gate insulating pattern GI may be between the gate electrode GE and the paired first source/drain patterns SD1 and between the gate electrode GE and the first to third semiconductor patterns SP1, SP2, and SP3.

The gate insulating pattern GI includes a high-k dielectric pattern HK, an inner spacer IS, a mask insulating pattern MI, and may include a horizontal insulating pattern HI. The high-k dielectric pattern HK encloses the gate electrode GE, in the inner regions IRG. The high-k dielectric pattern HK may be between the gate electrode GE and the paired first source/drain patterns SD1 and between the gate electrode GE and the first to third semiconductor patterns SP1, SP2, and SP3.

The high-k dielectric pattern HK may be formed of or include a high-k dielectric material whose dielectric constant is higher than that of silicon oxide. In an embodiment, the high-k dielectric pattern HK may be formed of or include, e.g., hafnium oxide, hafnium silicon oxide, hafnium zirconium oxide, hafnium tantalum oxide, lanthanum oxide, zirconium oxide, zirconium silicon oxide, tantalum oxide, titanium oxide, barium strontium titanium oxide, barium titanium oxide, strontium titanium oxide, lithium oxide, aluminum oxide, lead scandium tantalum oxide, or lead zinc niobate.

The inner spacer IS may be on a side surface SDc of the first source/drain pattern SD1. In an embodiment, the inner spacer IS may be in the inner region IRG to cover at least a portion of the side surface SDc of the first source/drain pattern SD1. A pair of inner spacers IS may be in the inner region IRG, and each of them may be on the side surface SDc of a corresponding one of the paired first source/drain patterns SD1. The inner spacer IS may be extended along the side surface SDc of the first source/drain pattern SD1. The inner spacer IS is between the first source/drain pattern SD1 and the high-k dielectric pattern HK and may separate them from each other. The inner spacer IS may be formed of or include a silicon-containing insulating material. In an embodiment, the inner spacer IS may be formed of or include, e.g., silicon oxide (SiO), silicon oxynitride (SiON), or silicon nitride (SiN).

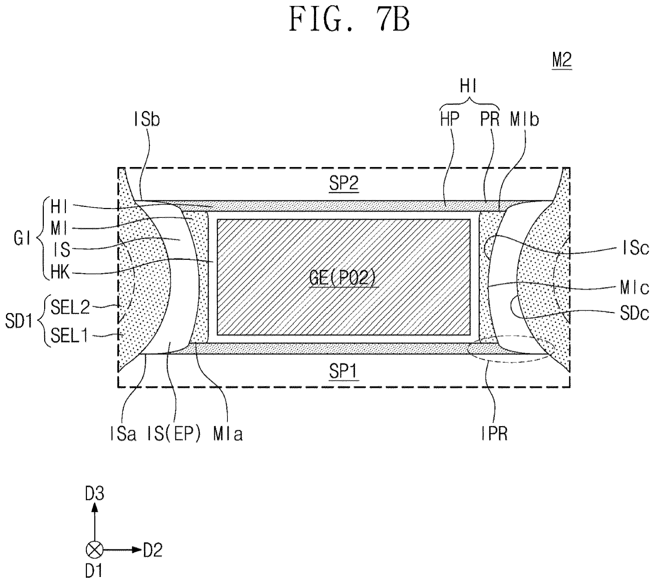

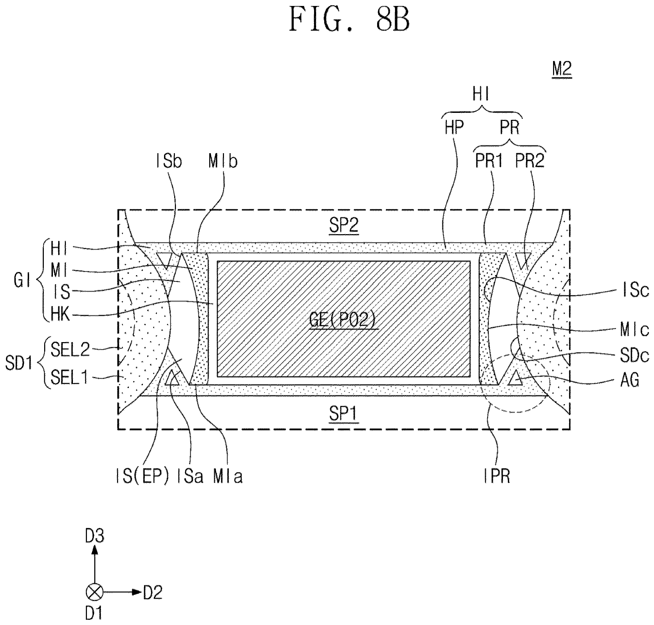

The mask insulating pattern MI may be on a side surface of the inner spacer IS. In an embodiment, the mask insulating pattern MI may be on an inner side surface of the inner spacer IS, as shown in FIG. 6B. In other embodiments, the mask insulating pattern MI may be on an outer side surface ISc of the inner spacer IS, as shown in FIG. 7B or 8B. In the inner region IRG, the mask insulating pattern MI may cover at least a portion of the side surface of the inner spacer IS. The mask insulating pattern MI may extend along the side surface of the inner spacer IS. The mask insulating pattern MI is between the high-k dielectric pattern HK and the inner spacer IS. The mask insulating pattern MI may be in contact with the high-k dielectric pattern HK and the inner spacer IS.

The mask insulating pattern MI may be spaced apart from the first source/drain pattern SD1 by the inner spacer IS. In an embodiment, a pair of mask insulating patterns MI may be in the inner region IRG, and each of them may be spaced apart from a corresponding one of the paired first source/drain patterns SD1. The mask insulating pattern MI may be spaced apart from the first to third semiconductor patterns SP1, SP2, and SP3 by the horizontal insulating pattern HI. In an embodiment, the mask insulating pattern MI may be spaced apart from the first semiconductor pattern SP1 by one of the paired horizontal insulating patterns HI and may be spaced apart from the second semiconductor pattern SP2 by the other.

The mask insulating pattern MI has an etch selectivity with respect to the inner spacer IS. In an embodiment, the mask insulating pattern MI may be formed of or include a material having an etch selectivity with respect to the material of the inner spacer IS. In an implementation, the mask insulating pattern MI may be formed of or include, e.g., silicon nitride (SiN), silicon oxynitride (SiON), silicon carbon nitride (SiCN), silicon carbon oxynitride (SiCON), aluminum oxide (AlO), lanthanum oxide (LaO), or titanium oxide (TiO). Here, the etch selectivity may mean that layers, which are exposed to an etchant material during a wet etching process, exhibit a difference, preferably a large difference, in etch rate therebetween.

The horizontal insulating pattern HI may be between the high-k dielectric pattern HK and the first to third semiconductor patterns SP1, SP2, and SP3. In an embodiment, a pair of horizontal insulating patterns HI may be in the inner region IRG. One of the paired horizontal insulating patterns HI may be between a top surface of the first semiconductor pattern SP1 and the high-k dielectric pattern HK, and the other may be between a bottom surface of the second semiconductor pattern SP2 and the high-k dielectric pattern HK. The paired horizontal insulating patterns HI may be spaced apart from each other with the gate electrode GE therebetween.

The horizontal insulating pattern HI may include a horizontal portion HP, which is between the high-k dielectric pattern HK and the corresponding semiconductor pattern SP1, SP2, or SP3, and a protruding portion PR, which is between the inner spacer IS and the corresponding semiconductor pattern SP1, SP2, or SP3. In an embodiment, one of the horizontal insulating patterns HI may include two protruding portions PR and one horizontal portion HP therebetween.

An inward protruding region IPR may be defined in a region, which is closer to the first source/drain pattern SD1 than the high-k dielectric pattern HK, and may be between the inner spacer IS and each of the first to third semiconductor patterns SP1, SP2, and SP3. The inward protruding region IPR may be formed by a wet etching process, which is performed to form the inner spacer IS and is performed as a part of a fabrication process to be described below. The protruding portion PR of the horizontal insulating pattern HI may fill the inward protruding region IPR.

The horizontal insulating pattern HI may be formed of or include a silicon-containing insulating material. In an embodiment, the horizontal insulating pattern HI may be formed of or include, e.g., silicon oxide (SiO), silicon oxynitride (SiON), or silicon nitride (SiN). In an embodiment, the horizontal insulating pattern HI may be formed of or include the same material as the inner spacer IS, and in this case, there may be no observable border between the horizontal insulating pattern HI and the inner spacer IS. In an embodiment, the horizontal insulating pattern HI may be formed of or include a material different from the inner spacer IS, and in this case, there may be an observable border between the horizontal insulating pattern HI and the inner spacer IS.

The gate insulating pattern GI may include an upper gate insulating pattern GI', and the upper gate insulating pattern GI' may be on the uppermost semiconductor pattern, e.g., the third semiconductor pattern SP3. The upper gate insulating pattern GI' may include an upper horizontal insulating pattern HI' and an upper high-k dielectric pattern HK'. The upper horizontal insulating pattern HI' may cover the uppermost semiconductor pattern. The upper high-k dielectric pattern HK' may cover the upper horizontal insulating pattern HI' and the side surfaces of the gate spacers GS. In an embodiment, the upper gate insulating pattern GI' need not include the same material as the mask insulating pattern MI.

A pair of the first source/drain patterns SD1 may be spaced apart from each other with the first channel pattern CH1 therebetween. The first source/drain pattern SD1 may have the side surface SDc protruding toward each of the first to third inner electrodes PO1, PO2, and PO3 of the gate electrode GE. The side surface SDc of the first source/drain pattern SD1 may have a profile that is convexly curved toward a corresponding portion of the first to third inner electrodes PO1, PO2, and PO3. The mask insulating pattern MI may have a side surface MIc facing the first source/drain pattern SD1. The side surface MIc of the mask insulating pattern MI may have a concave profile, which corresponds to the side surface SDc of the first source/drain pattern SD1 or is concavely curved toward the first to third inner electrodes PO1, PO2, and PO3 of the gate electrode GE.

The first source/drain pattern SD1 may include a first semiconductor layer SEL1 and a second semiconductor layer SEL2 on the first semiconductor layer SEL1. In the case where the first source/drain pattern SD1 is of an n-type, the first semiconductor layer SEL1 may be formed of or include the same semiconductor material, e.g., silicon (Si), as the second semiconductor layer SEL2. However, a concentration of the n-type impurities, e.g., phosphorus or arsenic, in the second semiconductor layer SEL2 may be higher than a concentration of the n-type impurities in the first semiconductor layer SEL1.

In the case where the first source/drain pattern SD1 has a p-type, the first semiconductor layer SEL1 may be formed of or include the same semiconductor material (e.g., silicon-germanium (SiGe)) as the second semiconductor layer SEL2. However, a germanium concentration of the second semiconductor layer SEL2 may be higher than a germanium concentration of the first semiconductor layer SEL1. In addition, a concentration of p-type impurities (e.g., boron) in the second semiconductor layer SEL2 may be higher than a concentration of p-type impurities in the first semiconductor layer SEL1.

According to an embodiment, the structure of the inner spacer IS, the mask insulating pattern MI, and the horizontal insulating pattern HI may be variously changed. Hereinafter, the structure of the inner spacer IS, the mask insulating pattern MI, and the horizontal insulating pattern HI will be described in more detail with reference to some embodiments.

Referring to FIGS. 6A and 6B, the mask insulating pattern MI may have a bottom surface MIa and a top surface MIb. The inner spacer IS may include a capping portion MC covering the bottom surface MIa or the top surface MIb of the mask insulating pattern MI and an extended portion EP covering the side surface MIc of the mask insulating pattern MI. In an embodiment, the inner spacer IS may cover at least a portion of a corresponding bottom or top surfaces MIa and MIb of the mask insulating pattern MI. In an implementation, the inner spacer IS may include a pair of capping portions MC, which respectively may cover the bottom and top surfaces MIa and MIb of the mask insulating pattern MI. In an implementation, the inner spacer IS may include one capping portion MC covering only one of the bottom and top surfaces MIa and MIb of the mask insulating pattern MI.

The mask insulating pattern MI may be buried in the inner spacer IS. In an embodiment, the mask insulating pattern MI may be buried in the inner spacer IS in a horizontal direction (i.e., the second direction D2). The mask insulating pattern MI may be buried in the inner spacer IS in an inward direction from the outer side surface ISc of the inner spacer IS. The side surface MIc of the mask insulating pattern MI may be in contact with an inner portion of the inner spacer IS.

In an embodiment, the inner spacer IS may be in contact with each of the first and second semiconductor patterns SP1 and SP2, as shown in FIG. 6B. In an embodiment, a bottom surface ISa of the inner spacer IS may be in contact with the first semiconductor pattern SP1, and a top surface ISb may be in contact with the second semiconductor pattern SP2. In an embodiment, the inner spacer IS may be spaced apart from at least one of the first and second semiconductor patterns SP1 and SP2.

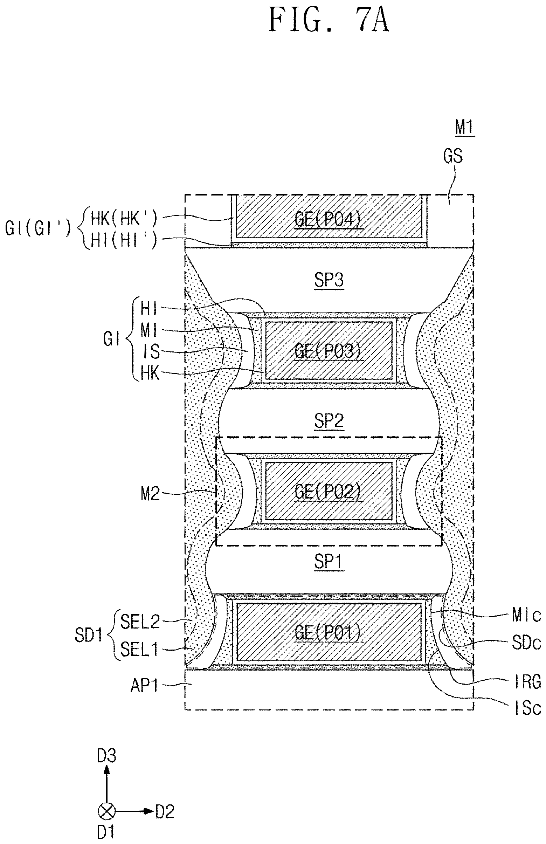

Referring to FIGS. 7A and 7B, the mask insulating pattern MI may protrude from the outer side surface ISc of the inner spacer IS toward the gate electrode GE. The mask insulating pattern MI may cover the outer side surface ISc of the inner spacer IS. The inner spacer IS may have a shape without the capping portion MC. Thus, the bottom and top surfaces MIa and MIb of the mask insulating pattern MI may not be covered by the inner spacer IS.

The protruding portion PR of the horizontal insulating pattern HI may fill the inward protruding region IPR. The protruding portion PR of the horizontal insulating pattern HI may extend from a region between the semiconductor pattern SP1, SP2, or SP3 and the mask insulating pattern MI to a region between the semiconductor pattern SP1, SP2, or SP3 and the inner spacer IS. The horizontal insulating pattern HI may cover the bottom and top surfaces MIa and MIb of the mask insulating pattern MI. In an embodiment, the horizontal insulating pattern HI may further cover at least a portion of a corresponding one of the bottom and top surfaces ISa and ISb of the inner spacer IS.

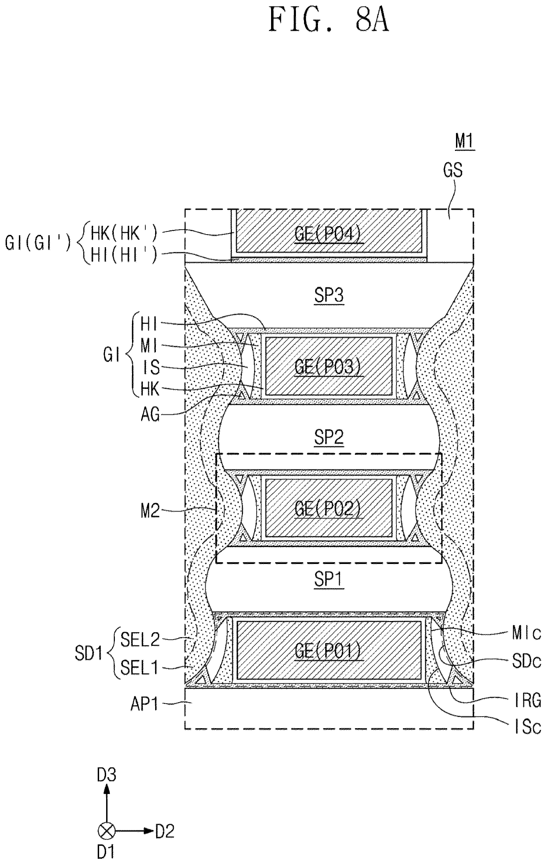

Referring to FIGS. 8A and 8B, the mask insulating pattern MI may protrude from the outer side surface ISc of the inner spacer IS toward the gate electrode GE. The mask insulating pattern MI may cover the outer side surface ISc of the inner spacer IS. The inner spacer IS may have a shape without the capping portion MC. Thus, the bottom and top surfaces MIa and MIb of the mask insulating pattern MI may not be covered with the inner spacer IS.

The protruding portion PR of the horizontal insulating pattern HI may include a first portion PR1 and a second portion PR2. The first portion PR1 may be in the inward protruding region IPR, which is defined between the inner spacer IS and each of the first to third semiconductor patterns SP1, SP2, and SP3. The second portion PR2 may extend from the first portion PR1 to a region between the inner spacer IS and the first source/drain pattern SD1.

In an embodiment, the horizontal insulating pattern HI may be provided to have an air gap AG therein, as shown in FIGS. 8A and 8B. The air gap AG may be spaced apart from the semiconductor pattern SP1, SP2, or SP3, the first source/drain pattern SD1, and the inner spacer IS. In an embodiment, the air gap AG may be in the second portion PR2 of the horizontal insulating pattern HI.

In an implementation, the horizontal insulating pattern HI may fully fill the inward protruding region IPR. In an embodiment, the air gap AG may be in the horizontal insulating pattern HI.

According to an embodiment, the protruding portion PR of the horizontal insulating pattern HI may be extended from the horizontal portion HP toward the inward protruding region IPR but does not extend to a region between the high-k dielectric pattern HK and the first source/drain pattern SD1. Thus, the high-k dielectric pattern HK may have a relatively unrounded corner in a region where the horizontal insulating pattern HI meets the mask insulating pattern MI. As a result, a distance between the gate electrode GE and the semiconductor pattern SP1, SP2, or SP3 in a vertical direction, i.e., the third direction D3 or a thickness of the gate insulating pattern GI, may be maintained to be constant regardless of a position in a horizontal direction, i.e., the second direction D2, and the electrical and reliability characteristics of the semiconductor device may be improved.

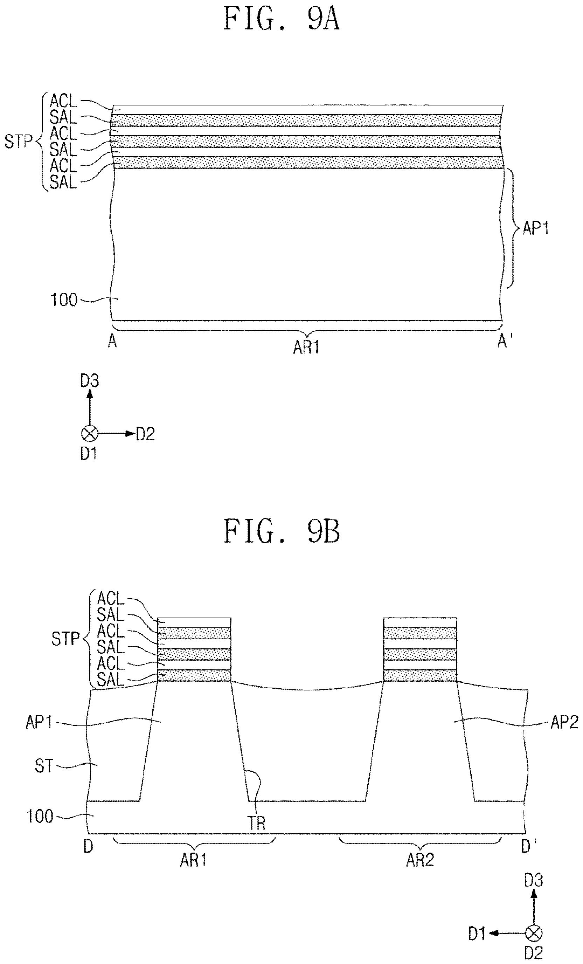

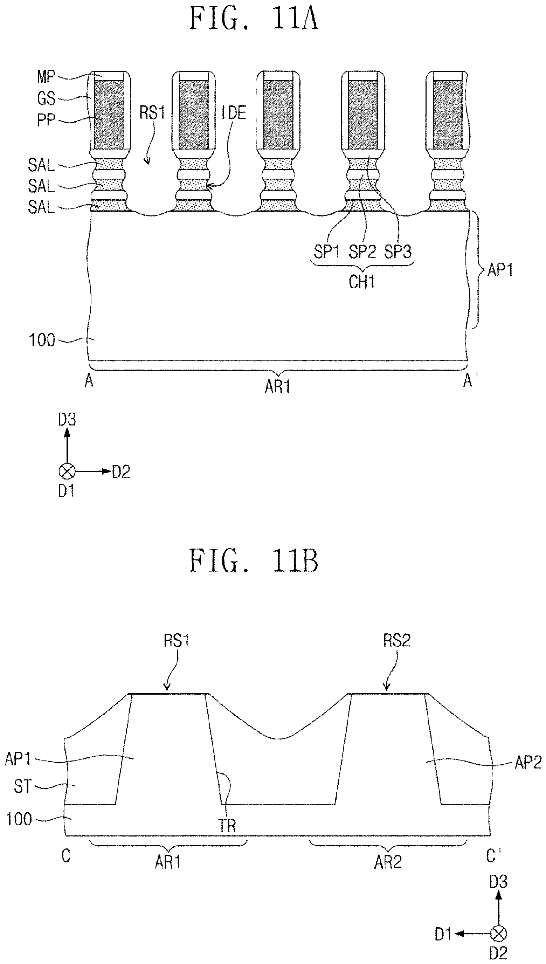

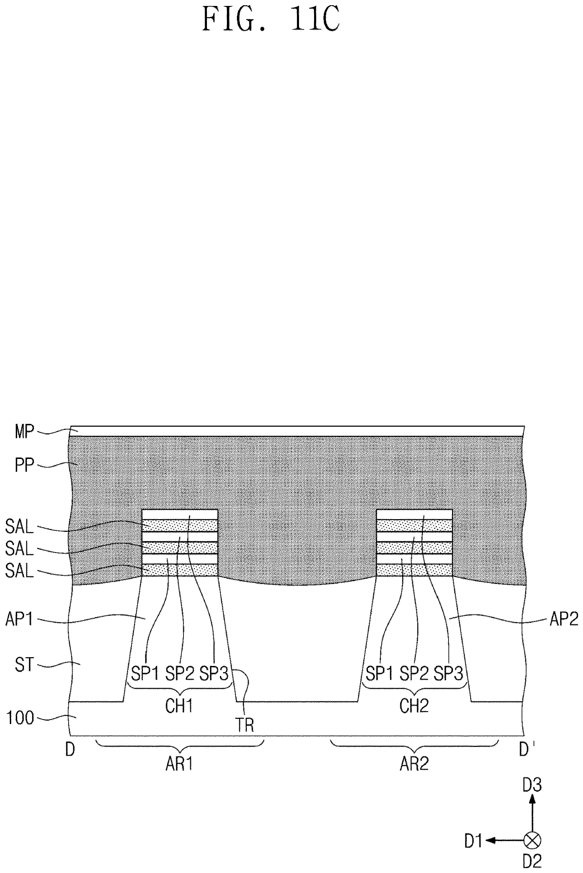

FIGS. 9A to 13C show sectional views of stages in a method of fabricating a semiconductor device, according to an embodiment. In detail, FIGS. 9A, 10A, 11A, 12A, and 13A show sectional views taken along a line A-A' of FIG. 4. FIGS. 11B, 12B, and 13B show sectional views taken along a line C-C' of FIG. 4. FIGS. 9B, 10B, 11C, 12C, and 13C show sectional views taken along a line D-D' of FIG. 4. Hereinafter, a method of fabricating a semiconductor device, according to an embodiment, will be described in more detail with reference to FIGS. 9A to 13C. For concise description, a previously described element may be identified by the same reference number without repeating an overlapping description thereof.

Referring to FIGS. 9A and 9B, the substrate 100 including the first and second active regions AR1 and AR2 may be provided. Active layers ACL and sacrificial layers SAL may be alternately stacked on the substrate 100. The active and sacrificial layers ACL and SAL may be formed of or include, e.g., of silicon (Si), germanium (Ge), or silicon germanium (SiGe), and the active and sacrificial layers ACL and SAL may be formed of different materials from each other.

The sacrificial layer SAL may be formed of or include a material having an etch selectivity with respect to the active layer ACL. In an implementation, the active layers ACL may be formed of or include silicon (Si), and the sacrificial layers SAL may be formed of or include silicon germanium (SiGe). A germanium concentration of each of the sacrificial layers SAL may range from 10 at% to 30 at%.

Mask patterns may be respectively formed on the first and second active regions AR1 and AR2 of the substrate 100. The mask pattern may be a line- or bar-shaped pattern that is extended in the second direction D2.

A patterning process using the mask patterns as an etch mask may be performed to form the trench TR defining the first and second active patterns AP1 and AP2. The first active pattern AP1 may be formed on the first active region AR1. The second active pattern AP2 may be formed on the second active region AR2.

A stacking pattern STP may be formed on each of the first and second active patterns AP1 and AP2. The stacking pattern STP may include the active layers ACL and the sacrificial layers SAL which are alternately stacked. The stacking pattern STP may be formed along with the first and second active patterns AP1 and AP2, during the patterning process.

The device isolation layer ST may be formed to fill the trench TR. In detail, an insulating layer may be formed on the substrate 100 to cover the first and second active patterns AP1 and AP2 and the stacking patterns STP. The device isolation layer ST may be formed by recessing the insulating layer to expose the stacking patterns STP.

The device isolation layer ST may be formed of or include an insulating material, e.g., silicon oxide. The stacking patterns STP may be placed at a level higher than the device isolation layer ST and may be exposed to the outside of the device isolation layer ST. In other words, the stacking patterns STP may protrude vertically above the device isolation layer ST.

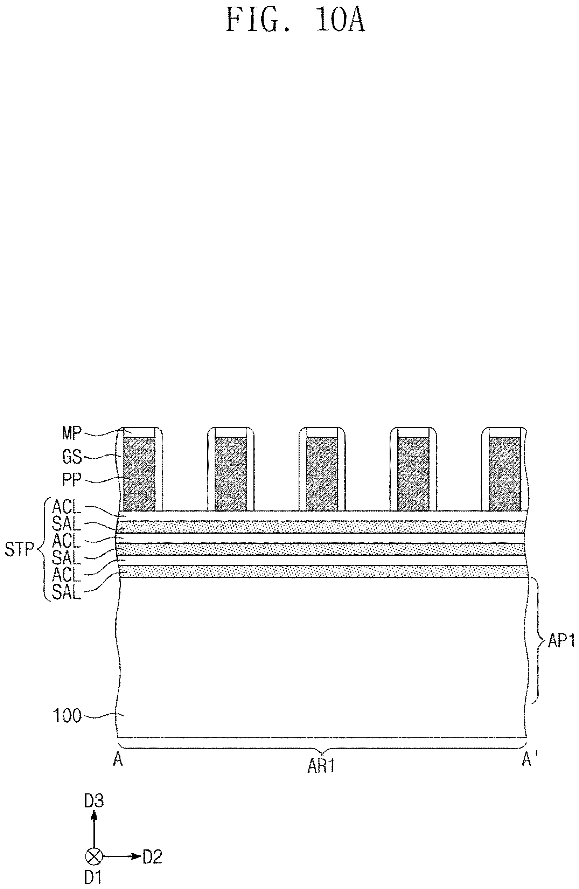

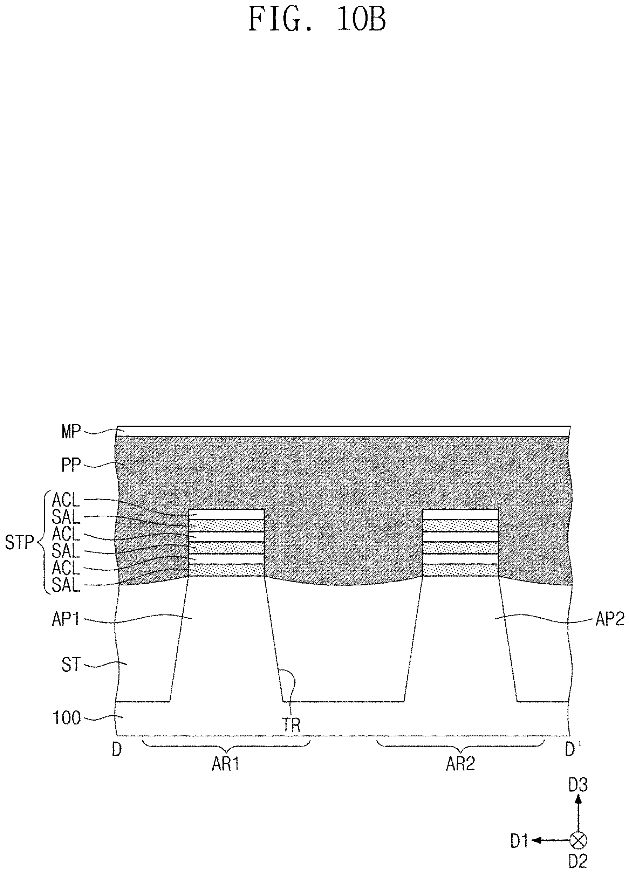

Referring to FIGS. 10A and 10B, sacrificial patterns PP may be formed on the substrate 100 to cross the stacking patterns STP. Each of the sacrificial patterns PP may be a line- or bar-shaped pattern extending in the first direction D1. The sacrificial patterns PP may be arranged at a first pitch in the second direction D2.

In an implementation, the formation of the sacrificial patterns PP may include forming a sacrificial layer on the substrate 100, forming hard mask patterns MP on the sacrificial layer, and patterning the sacrificial layer using the hard mask patterns MP as an etch mask. The sacrificial layer may be formed of or include polysilicon.

A pair of the gate spacers GS may be formed on opposite side surfaces of each of the sacrificial patterns PP. The formation of the gate spacers GS may include conformally forming a gate spacer layer on the substrate 100 and anisotropically etching the gate spacer layer. In an embodiment, the gate spacer GS may be a multi-layered structure including at least two layers.

Referring to FIGS. 11A to 11C, the first recesses RS1 may be formed in the stacking pattern STP on the first active pattern AP1. The second recesses RS2 may be formed in the stacking pattern STP on the second active pattern AP2. During the formation of the first and second recesses RS1 and RS2, the device isolation layer ST may also be recessed at both sides of each of the first and second active patterns AP1 and AP2 (e.g., see FIG. 11B).

In detail, the first recesses RS1 may be formed by etching the stacking pattern STP on the first active pattern AP1 using the hard mask patterns MP and the gate spacers GS as an etch mask. The first recess RS1 may be formed between a pair of the sacrificial patterns PP.

In an embodiment, the formation of the first recess RS1 may include additionally performing a selective etching process on exposed portions of the sacrificial layers SAL. Each of the sacrificial layers SAL may be indented by the selective etching process to form an indent region IDE. Accordingly, the first recess RS1 may be formed to have an inner side surface of a wavy shape. The second recesses RS2 in the stacking pattern STP on the second active pattern AP2 may be formed by the same method as that for the first recesses RS1.

The first to third semiconductor patterns SP1, SP2, and SP3, which are sequentially stacked between adjacent ones of the first recesses RS1, may be respectively formed from the active layers ACL. The first to third semiconductor patterns SP1, SP2, and SP3 between adjacent ones of the first recesses RS1 may constitute the first channel pattern CH1. The first to third semiconductor patterns SP1, SP2, and SP3 between adjacent ones of the second recesses RS2 may constitute the second channel pattern CH2.

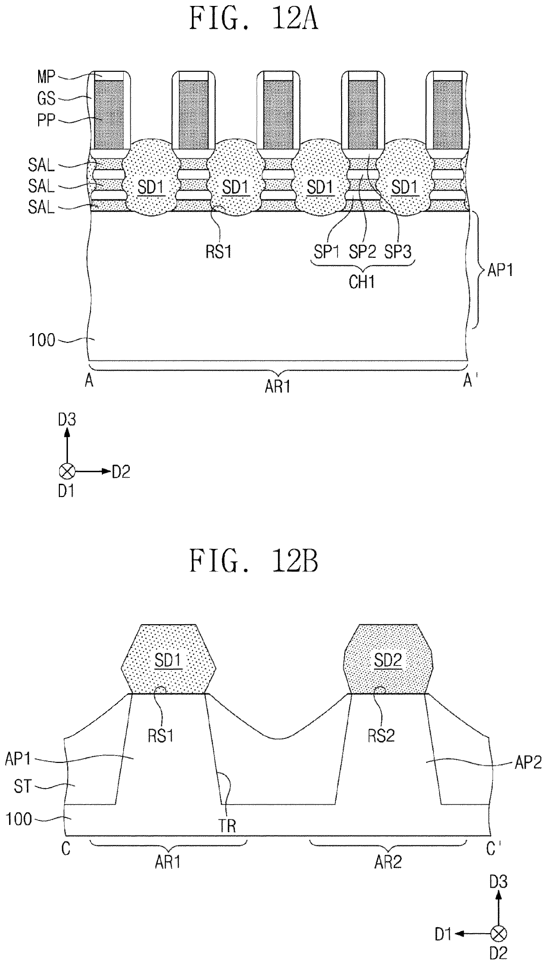

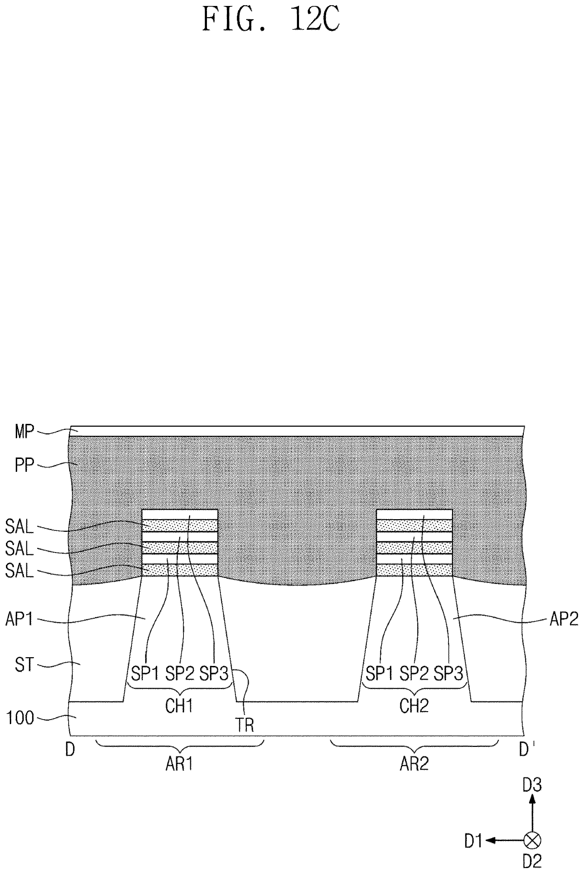

Referring to FIGS. 12A to 12C, the first source/drain patterns SD1 may be formed in the first recesses RS1, respectively. In detail, a SEG process, in which an inner surface of the first recess RS1 is used as a seed layer, may be performed to form an epitaxial layer filling the first recess RS1. The epitaxial layer may be grown using the first to third semiconductor patterns SP1, SP2, and SP3 and the substrate 100, which are exposed by the first recess RS1, as the seed layer. In an embodiment, the SEG process may include a chemical vapor deposition (CVD) process or a molecular beam epitaxy (MBE) process.

In an embodiment, the first source/drain pattern SD1 may include the same semiconductor element, e.g., Si, as the substrate 100. During the formation of the first source/drain pattern SD1, the first source/drain pattern SD1 may be doped in-situ with n-type impurities, e.g., phosphorus, arsenic, or antimony. In an implementation, impurities may be injected into the first source/drain pattern SD1, after the formation of the first source/drain pattern SD1.

The second source/drain patterns SD2 may be formed in the second recesses RS2, respectively. In an implementation, the second source/drain pattern SD2 may be formed by a SEG process using an inner surface of the second recess RS2 as a seed layer.

In an embodiment, the second source/drain pattern SD2 may be formed of or include a semiconductor material, e.g., SiGe, whose lattice constant is greater than that of a semiconductor material of the substrate 100. During the formation of the second source/drain pattern SD2, the second source/drain pattern SD2 may be doped in-situ with p-type impurities, e.g., boron, gallium, or indium. In an implementation, impurities may be injected into the second source/drain pattern SD2, after the formation of the second source/drain pattern SD2.

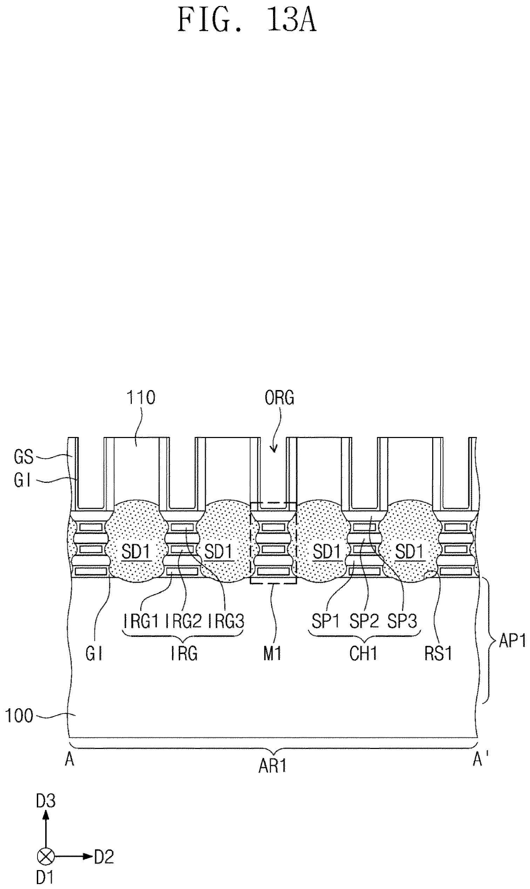

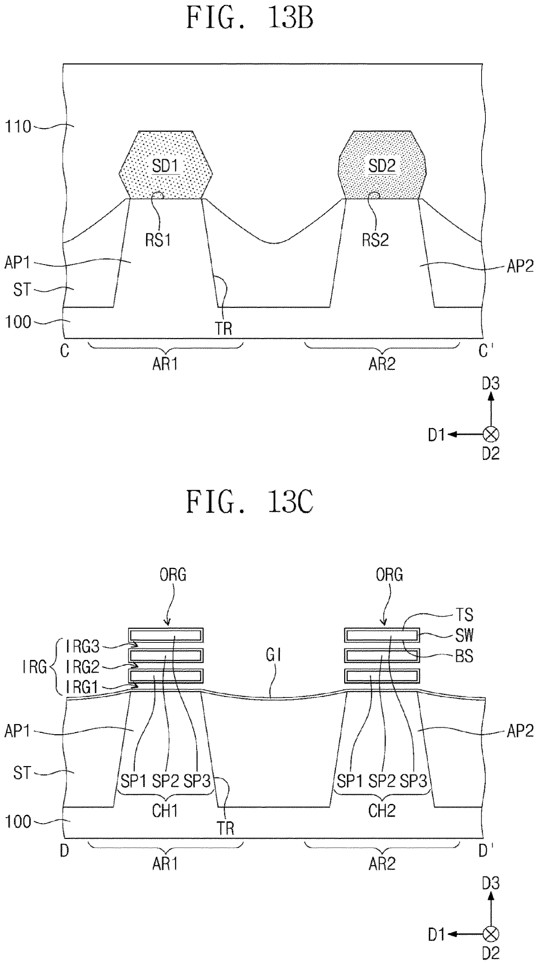

Referring to FIGS. 13A to 13C, the first interlayer insulating layer 110 may be formed to cover the first and second source/drain patterns SD1 and SD2, the hard mask patterns MP, and the gate spacers GS. In an embodiment, the first interlayer insulating layer 110 may be formed of or include silicon oxide.

The first interlayer insulating layer 110 may be planarized to expose the top surfaces of the sacrificial patterns PP. The planarization of the first interlayer insulating layer 110 may be performed using an etch-back or chemical-mechanical polishing (CMP) process. The hard mask patterns MP may be fully removed during the planarization process. As a result, a top surface of the first interlayer insulating layer 110 may be coplanar with the top surfaces of the sacrificial patterns PP and the top surfaces of the gate spacers GS.

In an embodiment, the exposed sacrificial patterns PP may be selectively removed. As a result of the removal of the sacrificial patterns PP, an outer region ORG exposing the first and second channel patterns CH1 and CH2 may be formed (e.g., see FIG. 13C). The removal of the sacrificial patterns PP may include a wet etching process which is performed using an etching solution capable of selectively etching polysilicon.

The sacrificial layers SAL exposed through the outer region ORG may be selectively removed to form inner regions IRG (e.g., see FIG. 13C). In detail, a process of selectively etching the sacrificial layers SAL may be performed to leave the first to third semiconductor patterns SP1, SP2, and SP3 and to remove only the sacrificial layers SAL. The etching process may be chosen to have a high etch rate for a material, e.g., SiGe, having a relatively high germanium concentration. In an embodiment, the etching process may be chosen to have a high etch rate for a silicon germanium layer whose germanium concentration is higher than 10 at%.

During the etching process, the sacrificial layers SAL on the first and second active regions AR1 and AR2 may be removed. The etching process may be a wet etching process. An etchant material, which is used in the etching process, may be chosen to quickly remove the sacrificial layer SAL having a relatively high germanium concentration.

Referring to FIG. 13C, as a result of the selective removal of the sacrificial layers SAL, only the stacked first to third semiconductor patterns SP1, SP2, and SP3 might be left on each of the first and second active patterns AP1 and AP2. Hereinafter, empty regions, which are formed by removing the sacrificial layers SAL, will be referred to as first to third inner regions IRG1, IRG2, and IRG3, respectively. In detail, the first inner region IRG1 may be formed between the active pattern AP1 or AP2 and the first semiconductor pattern SP1, the second inner region IRG2 may be formed between the first semiconductor pattern SP1 and the second semiconductor pattern SP2, and the third inner region IRG3 may be formed between the second semiconductor pattern SP2 and the third semiconductor pattern SP3.

Referring back to FIGS. 13A to 13C, the gate insulating pattern GI may be formed on the exposed first to third semiconductor patterns SP1, SP2, and SP3. The gate insulating pattern GI may be formed to enclose each of the first to third semiconductor patterns SP1, SP2, and SP3. The gate insulating pattern GI may be formed in each of the first to third inner regions IRG1, IRG2, and IRG3. The gate insulating pattern GI may be formed in the outer region ORG.

Referring back to FIGS. 5A to 5D, the gate electrode GE may be formed on the gate insulating pattern GI. The gate electrode GE may include the first to third inner electrodes PO1, PO2, and PO3, which are respectively formed in the first to third inner regions IRG1, IRG2, and IRG3, and the outer electrode PO4, which is formed in the outer region ORG. The gate electrode GE may be vertically recessed to have a reduced height. The gate capping pattern GP may be formed on the recessed gate electrode GE.

The second interlayer insulating layer 120 may be formed on the first interlayer insulating layer 110. The second interlayer insulating layer 120 may be formed of or include silicon oxide. The active contacts AC may be formed to penetrate the second interlayer insulating layer 120 and the first interlayer insulating layer 110 and may be electrically connected to the first and second source/drain patterns SD1 and SD2. The gate contact GC may be formed to penetrate the second interlayer insulating layer 120 and the gate capping pattern GP and may be electrically connected to the gate electrode GE.

The formation of each of the active and gate contacts AC and GC may include forming the barrier pattern BM and forming the conductive pattern FM on the barrier pattern BM. The barrier pattern BM may be conformally formed and may include a metal layer and a metal nitride layer. The conductive pattern FM may be formed of or include a low resistance metal.

The division structures DB may be respectively formed in the first and second borders BD1 and BD2 of the single height cell SHC. The division structure DB may penetrate the gate capping pattern GP and the gate electrode GE and may be extended into the active pattern AP1 or AP2. The division structure DB may be formed of or include an insulating material, e.g., silicon oxide or silicon nitride.

The third interlayer insulating layer 130 may be formed on the active contacts AC and the gate contacts GC. The first metal layer M1 may be formed in the third interlayer insulating layer 130. The fourth interlayer insulating layer 140 may be formed on the third interlayer insulating layer 130. The second metal layer M2 may be formed in the fourth interlayer insulating layer 140.

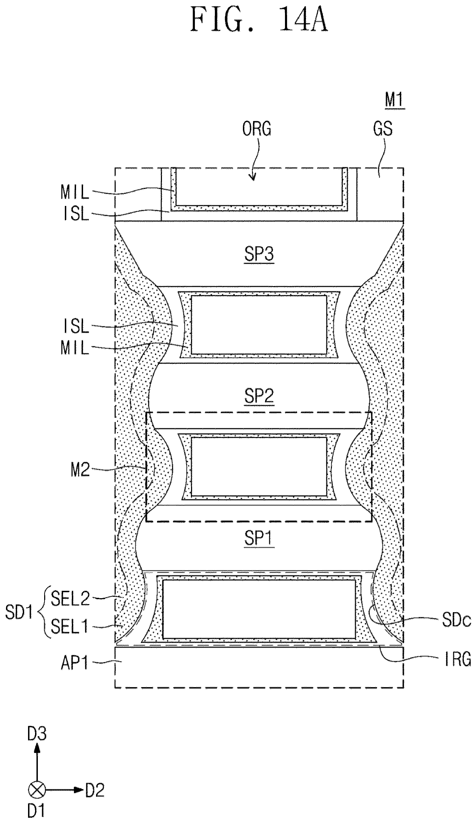

Hereinafter, a process of forming the gate insulating pattern GI will be described in more detail with reference to FIGS. 14A to 20B. For concise description, a previously described element may be identified by the same reference number without repeating an overlapping description thereof.

FIGS. 14A to 16B are enlarged sectional views illustrating a portion `M1' of FIG. 13A and illustrating a method of fabricating the semiconductor device of FIGS. 6A and 6B.

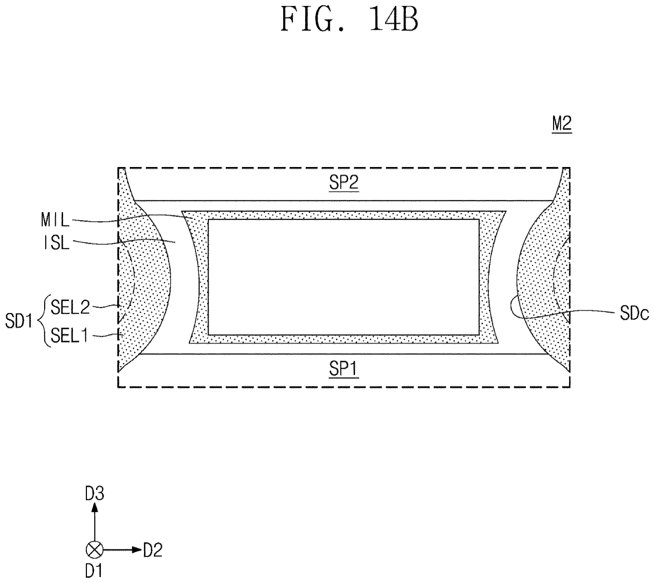

Referring to FIGS. 14A and 14B, the sacrificial layers SAL may be selectively removed to form the inner regions IRG1, IRG2, and IRG3 and the outer region ORG, as shown above. Due to the indent region IDE shown in FIG. 11A, the side surface SDc of the first source/drain pattern SD1 may have a profile protruding toward each of the inner regions IRG1, IRG2, and IRG3.

An inner spacer layer ISL may be formed on the first to third inner regions IRG1, IRG2, and IRG3 and the outer region ORG. The formation of the inner spacer layer ISL may include depositing the inner spacer layer ISL on side surfaces of the first to third inner regions IRG1, IRG2, and IRG3 and the outer region ORG. The inner spacer layer ISL may be formed by a deposition process, e.g., an ALD or CVD process. The inner spacer layer ISL may be formed to partially, i.e., not fully, fill the inner region IRG1, IRG2, or IRG3. Due to an aspect ratio of the inner region IRG1, IRG2, or IRG3, the inner spacer layer ISL may be formed to have a varying thickness depending on a position. In an embodiment, a thickness of the inner spacer layer ISL, which is measured in a horizontal direction, i.e., the second direction D2, on the first source/drain pattern SD1, may be larger than a thickness measured in a vertical direction, i.e., the third direction D3, on the semiconductor pattern SP1, SP2, or SP3. In an implementation, the inner spacer layer ISL may be formed of or include at least one of silicon oxide, silicon oxynitride, or silicon nitride.

Thereafter, a mask insulating layer MIL may be formed on the first to third inner regions IRG1, IRG2, and IRG3 and the outer region ORG. The formation of the mask insulating layer MIL may include depositing the mask insulating layer MIL on inner surfaces of the first to third inner regions IRG1, IRG2, and IRG3 and the outer region ORG. The mask insulating layer MIL may be formed in the inner regions IRG1, IRG2, and IRG3 and the outer region ORG to cover the inner spacer layer ISL. The mask insulating layer MIL may be formed to partially, i.e., not fully, fill the inner region IRG1, IRG2, or IRG3. Due to an aspect ratio of the inner region IRG1, IRG2, or IRG3, the mask insulating layer MIL may have a position-dependent thickness. In an embodiment, a thickness of the mask insulating layer MIL, which is measured in a horizontal direction, i.e., the second direction D2, on the first source/drain pattern SD1, may be larger than a thickness measured in a vertical direction, i.e., the third direction D3, on the semiconductor pattern SP1, SP2, or SP3.

The mask insulating layer MIL may have an etch selectivity with respect to the inner spacer layer ISL. In an implementation, the mask insulating layer MIL may be formed of or include a material having an etch selectivity with respect to the material, which is included in the inner spacer layer ISL. In an embodiment, the inner spacer layer ISL may be formed of or include silicon oxide (SiO), and here, the mask insulating layer MIL may be formed of or include materials, e.g., silicon nitride (SiN) and silicon oxynitride (SiON), having an etch selectivity with respect to the silicon oxide. Here, etch selectivity may mean that layers, which are exposed to an etchant material during a wet etching process, exhibit a difference, preferably a large difference, in etch rate therebetween.

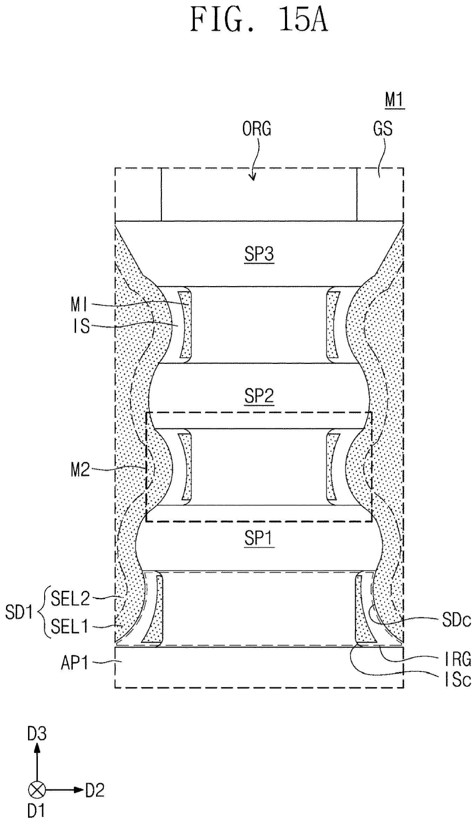

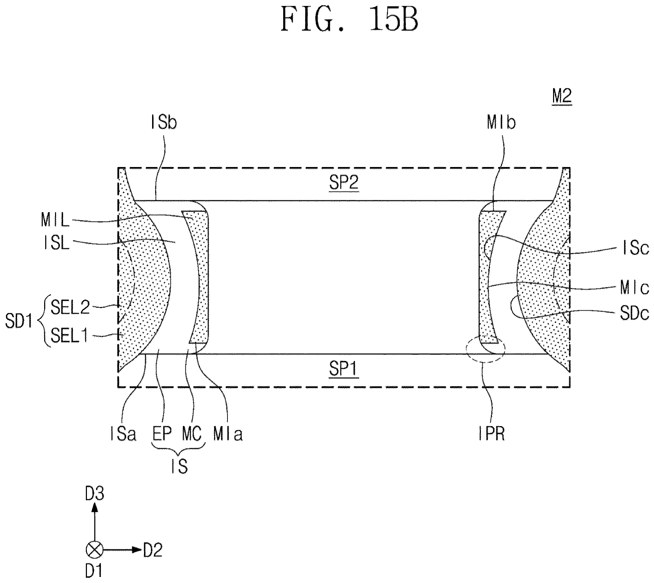

Referring to FIGS. 15A and 15B, an etching process may be performed on the inner spacer layer ISL using the mask insulating layer MIL as an etch mask. The etching process may include a wet etching process.

Thicknesses of the mask insulating layer MIL and the inner spacer layer ISL may vary depending on a position, as described above. Thus, the mask insulating layer MIL and the inner spacer layer ISL on the semiconductor pattern SP1, SP2, or SP3 may be removed, and the mask insulating layer MIL and the inner spacer layer ISL may be left on the first source/drain pattern SD1. A remaining portion of the mask insulating layer MIL and a remaining portion of the inner spacer layer ISL may serve as the mask insulating pattern MI and the inner spacer IS, respectively. As a result of the etching process, the semiconductor pattern SP1, SP2, or SP3 may be exposed on the inner region IRG1, IRG2, or IRG3.

A relative structure and profile of the inner spacer IS and the mask insulating pattern MI may vary depending on an etch selectivity between two elements and an etching amount. In the case where an etching amount of the inner spacer layer ISL is relatively small, the inner spacer IS may include the capping portion MC, as shown in FIG. 15B. The mask insulating pattern MI may be buried in the inner spacer IS. Since the mask insulating pattern MI is used as an etch mask, the inner spacer IS between the mask insulating pattern MI and the semiconductor pattern SP1, SP2, or SP3 may be selectively etched to form the inward protruding region IPR.

The mask insulating layer MIL and the inner spacer layer ISL in the outer region ORG may be more greatly influenced by the etching process, compared with the mask insulating layer MIL and the inner spacer layer ISL in the inner region IRG1, IRG2, or IRG3. Thus, the mask insulating layer MIL and the inner spacer layer ISL in the outer region ORG may be fully removed by the etching process. A top surface of the uppermost semiconductor pattern, e.g., the third semiconductor pattern SP3, may be exposed in the outer region ORG.

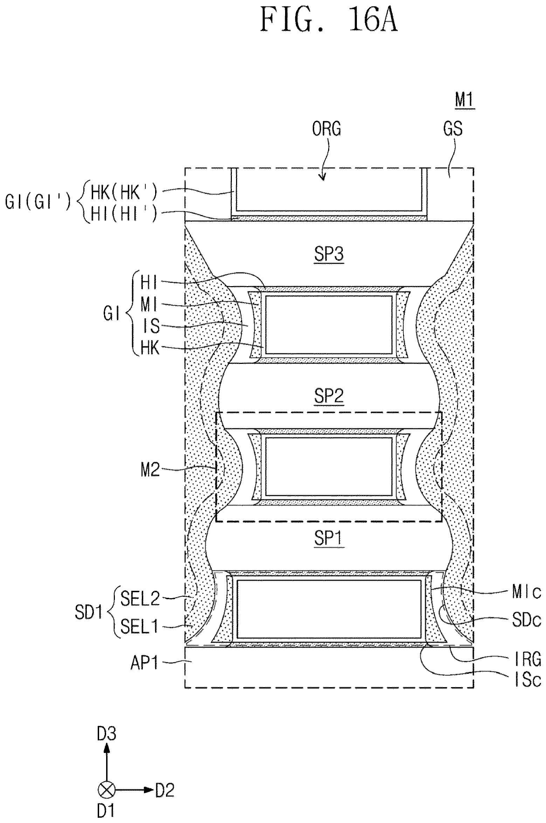

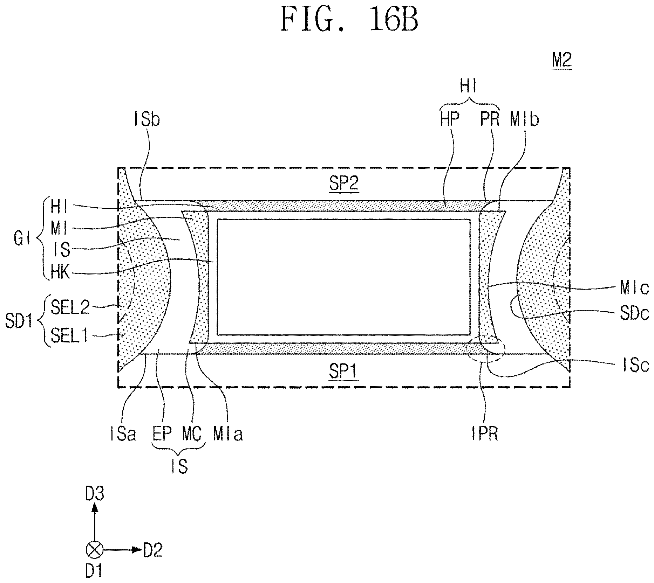

Referring to FIGS. 16A and 16B, the horizontal insulating pattern HI may be formed on the inner regions IRG1, IRG2, and IRG3 and the outer region ORG. The formation of the horizontal insulating pattern HI may include selectively depositing the horizontal insulating pattern HI. In an implementation, the horizontal insulating pattern HI may be selectively deposited on exposed surfaces of the semiconductor pattern SP1, SP2, or SP3 and the inner spacer IS. In an embodiment, the horizontal insulating pattern HI need not be deposited on an exposed surface of the mask insulating pattern MI. However, as the deposition process is performed, the horizontal insulating pattern HI, which is deposited on the exposed surfaces of the semiconductor pattern SP1, SP2, or SP3 and the inner spacer IS, may cover a portion of the mask insulating pattern MI. The horizontal insulating pattern HI need not be formed on the gate spacers GS.

The high-k dielectric pattern HK may be formed in the outer region ORG and the inner regions IRG1, IRG2, and IRG3. In an embodiment, the high-k dielectric pattern HK may be conformally formed. That is, a thickness of the high-k dielectric pattern HK in the second direction D2 may be substantially equal to a thickness parallel to the third direction D3.

Thereafter, the semiconductor device may be fabricated using the afore-described fabrication method.

According to an embodiment, the mask insulating pattern MI may be used as an etch mask in an etching process, which is performed to form the inner spacer IS. Thus, even after the etching process, the inner spacer IS may have a relatively large thickness on the first source/drain pattern SD1. As a result, a leakage current of a transistor may be reduced, and the electrical and reliability characteristics of the semiconductor device may be improved.

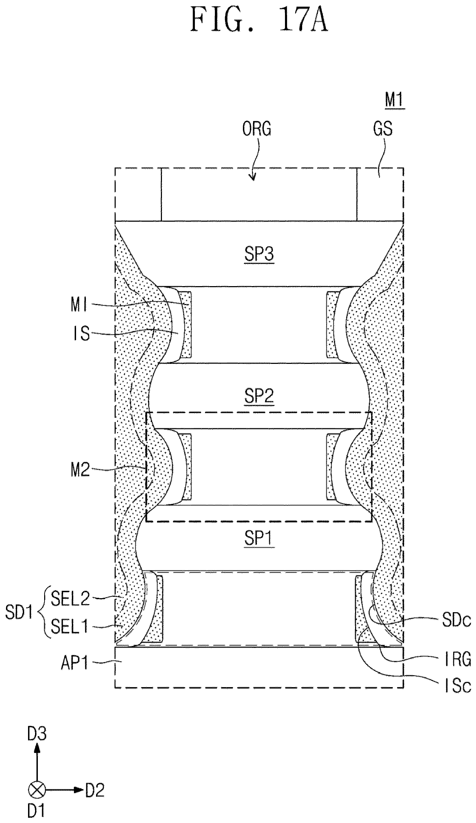

FIGS. 17A to 18B are enlarged sectional views illustrating a portion `M1' of FIG. 13A and illustrating a method of fabricating the semiconductor device of FIGS. 7A and 7B.

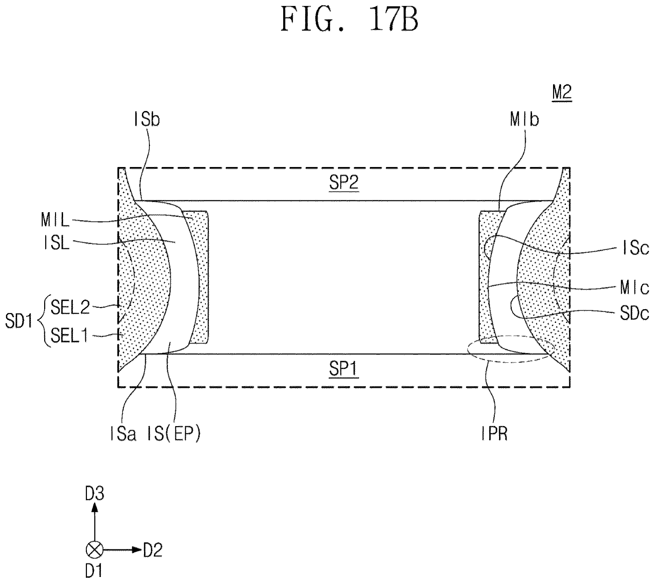

Referring to FIGS. 17A and 17B, when an etching process is performed to form the mask insulating pattern MI and the inner spacer IS, the inner spacer IS may be etched in a greater amount than that in the embodiment described with reference to FIGS. 15A and 15B. Thus, the inward protruding region IPR may be formed to a region near the first source/drain pattern SD1. The mask insulating pattern MI may be formed to have a shape protruding from the outer side surface ISc of the inner spacer IS. The bottom and top surfaces MIa and MIb of the mask insulating pattern MI may be exposed to the outside.

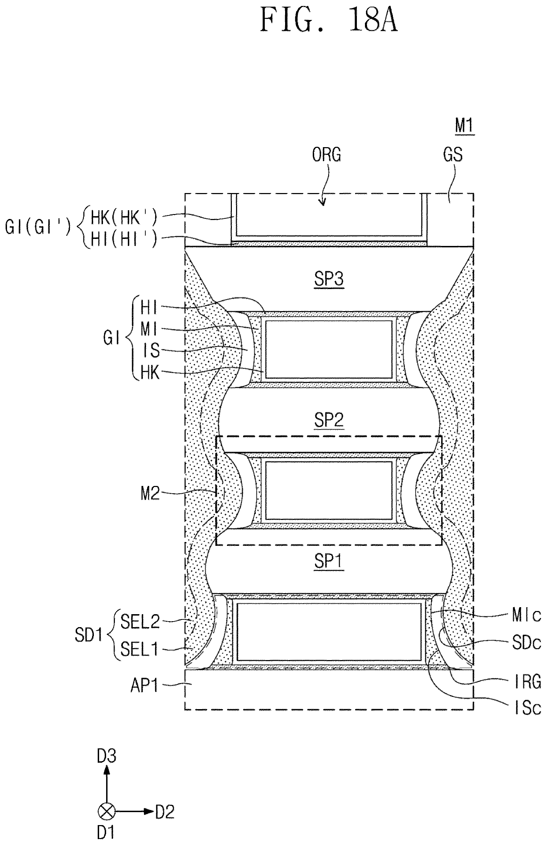

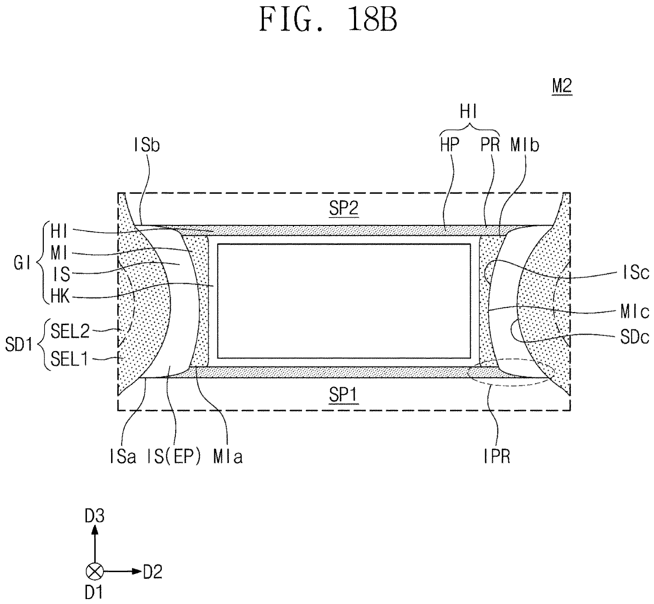

Referring to FIGS. 18A and 18B, the horizontal insulating pattern HI may be formed on the inner regions IRG1, IRG2, and IRG3 and the outer region ORG. In an embodiment, the horizontal insulating pattern HI may not be deposited on an exposed surface of the mask insulating pattern MI. However, a final structure of the horizontal insulating pattern HI may be formed to cover the exposed bottom and top surfaces MIa and MIb of the mask insulating pattern MI.

Thereafter, the semiconductor device may be fabricated using the afore-described fabrication method.

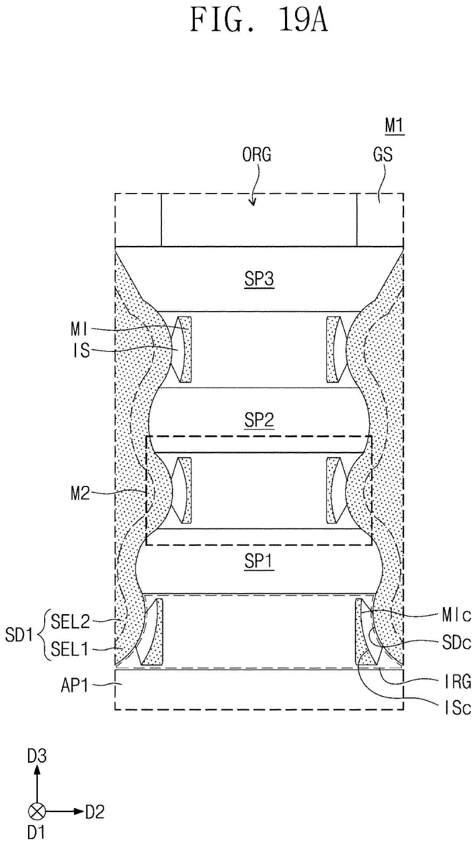

FIGS. 19A to 20B are enlarged sectional views illustrating a portion `M1' of FIG. 13A and illustrating a method of fabricating the semiconductor device of FIGS. 8A and 8B.

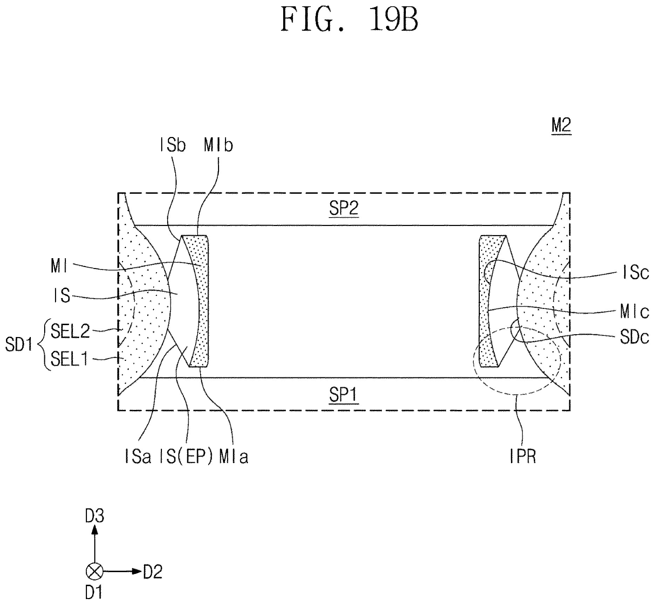

Referring to FIGS. 19A and 19B, when an etching process is performed to form the mask insulating pattern MI and the inner spacer IS, the inner spacer IS may be etched in a greater amount than that in the embodiment described with reference to FIGS. 17A and 17B. Thus, the inward protruding region IPR may be formed in a space between the inner spacer IS and the first source/drain pattern SD1. The mask insulating pattern MI may be formed to have a shape protruding from the outer side surface ISc of the inner spacer IS. The bottom and top surfaces MIa and MIb of the mask insulating pattern MI may be exposed to the outside.

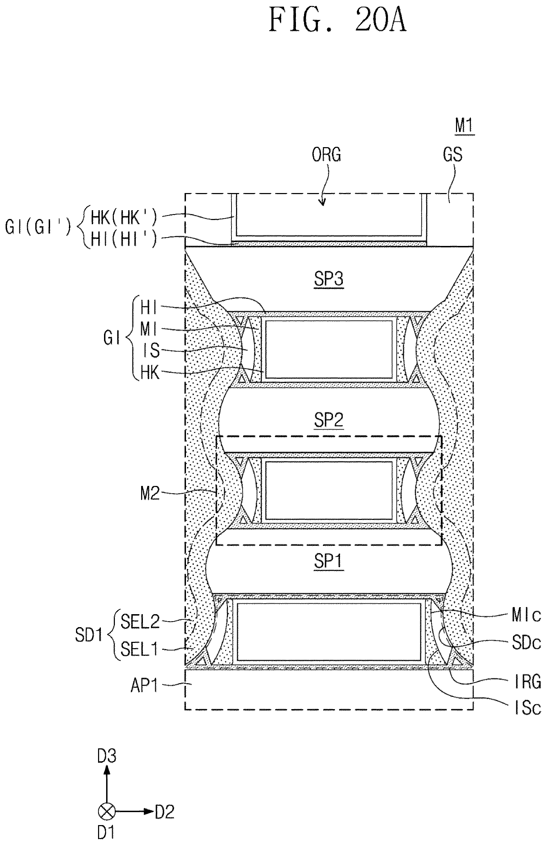

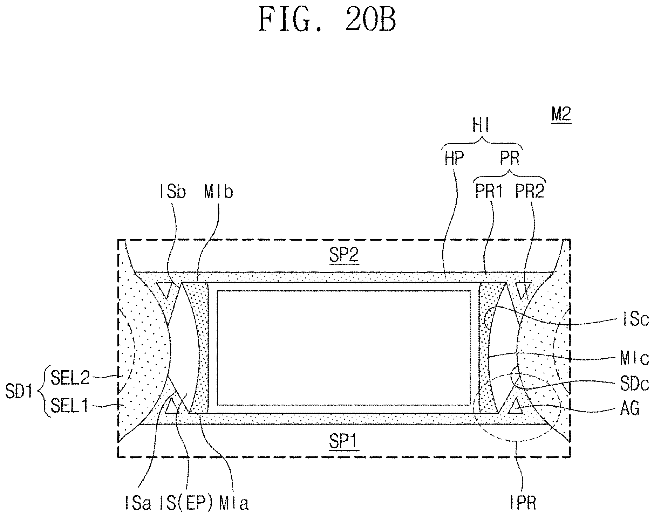

Referring to FIGS. 20A and 20B, the horizontal insulating pattern HI may be formed on the inner regions IRG1, IRG2, and IRG3 and the outer region ORG. The horizontal insulating pattern HI may be selectively deposited on exposed surfaces of the semiconductor pattern SP1, SP2, or SP3, the inner spacer IS, and the first source/drain pattern SD1. The selective deposition of the horizontal insulating pattern HI may include repeating a selective deposition step. As the selective deposition step is repeated, the horizontal insulating pattern HI may be grown to fill a space between the semiconductor pattern SP1, SP2, or SP3 and the mask insulating pattern MI. Here, a region between the inner spacer IS, which has a relatively large volume, and the first source/drain pattern SD1 may not be completely filled by the horizontal insulating pattern HI. Thus, the air gap AG may be formed in the horizontal insulating pattern HI. In an embodiment, the horizontal insulating pattern HI may be formed between the inner spacer IS and the first source/drain pattern SD1 and the air gap AG may not be formed in the horizontal insulating pattern HI.

Thereafter, the semiconductor device may be fabricated using the afore-described fabrication method.

According to an embodiment, a high-k dielectric pattern HK may have a relatively unrounded corner in a region where a horizontal insulating pattern HI meets a mask insulating pattern MI. As a result, a distance between a gate electrode GE and a semiconductor pattern SP1, SP2, or SP3 in a vertical direction, i.e., a thickness of a gate insulating pattern, may be maintained to be constant regardless of a position in a horizontal direction, and the electrical and reliability characteristics of the semiconductor device may be improved.

In addition, since the mask insulating pattern MI is used as an etch mask for forming an inner spacer IS, the inner spacer IS may have a relatively large thickness on a source/drain pattern SD1 or SD2. As a result, a leakage current of a transistor may be reduced, and the electrical and reliability characteristics of the semiconductor device may be improved.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the present invention as set forth in the following claims.

## Claims

1. A semiconductor device, comprising:
a substrate (100) including an active pattern (AP);
first and second semiconductor patterns (SP1, SP2) on the active pattern and vertically spaced apart from each other;
a source/drain pattern (SD) connected to the first and second semiconductor patterns;
a gate electrode (GE; PO2) between the first and second semiconductor patterns; and
a gate insulating pattern (GI) enclosing the gate electrode,
wherein the gate insulating pattern (GI) includes:
a high-k dielectric pattern (HK) enclosing the gate electrode (GE),
an inner spacer (IS) between the high-k dielectric pattern and the source/drain pattern, and
a mask insulating pattern (MI) having an etch selectivity with respect to the inner spacer between the high-k dielectric pattern and the inner spacer.

2. The semiconductor device as claimed in claim 1, wherein:
the mask insulating pattern has a side surface facing the inner spacer; and
the side surface of the mask insulating pattern has a profile that is concave toward the gate electrode.

3. The semiconductor device as claimed in claim 1 or 2, wherein the mask insulating pattern is spaced apart from the first semiconductor pattern.

4. The semiconductor device as claimed in claim 1, 2, or 3, wherein the mask insulating pattern includes silicon nitride, silicon oxynitride, silicon carbon nitride, silicon carbon oxynitride, aluminum oxide, lanthanum oxide, or titanium oxide.

5. The semiconductor device as claimed in any one of claims 1 to 4, wherein at least a portion of the mask insulating pattern is buried in the inner spacer.

6. The semiconductor device as claimed in any one of claims 1 to 5, wherein the inner spacer covers at least one of a top and bottom surface of the mask insulating pattern.

7. The semiconductor device as claimed in any one of claims 1 to 6, wherein:
the inner spacer has an outer side surface facing the gate electrode; and
the mask insulating pattern protrudes from the outer side surface of the inner spacer toward the gate electrode.

8. The semiconductor device as claimed in any one of claims 1 to 7, further including a horizontal insulating pattern between the high-k dielectric pattern and the first semiconductor pattern and extending to a region between the first semiconductor pattern and the inner spacer.

9. The semiconductor device as claimed in claim 8, wherein the horizontal insulating pattern extends to a region between the inner spacer and the source/drain pattern.

10. The semiconductor device as claimed in claim 8 or 9, wherein the horizontal insulating pattern has an air gap therein.

11. A method of fabricating a semiconductor device, the method comprising:
forming a stacking pattern including active layers and sacrificial layers, which are alternately stacked on top of each other;
forming a sacrificial pattern on the stacking pattern;
etching the stacking pattern and the active layers using the sacrificial pattern as a mask to form a pair of recesses at both sides of the sacrificial pattern and form a first semiconductor pattern and a second semiconductor pattern, which are vertically spaced apart from each other, from a remaining portion of the active layers;
forming a pair of source/drain patterns in the pair of recesses;
removing the sacrificial pattern and the sacrificial layers to expose the first and second semiconductor patterns; and
sequentially forming a gate insulating pattern and a gate electrode on the exposed surfaces of the first and second semiconductor patterns,
wherein an inner region is defined between the pair of source/drain patterns and between the first and second semiconductor patterns,
wherein the forming of the gate insulating pattern includes:
forming an inner spacer layer to cover an inner side surface of the inner region,
forming a mask insulating layer in the inner region to cover the inner spacer layer, and
etching the inner spacer layer using the mask insulating layer as an etch mask to form an inner spacer and form a mask insulating pattern from a remaining portion of the mask insulating layer.

12. The method as claimed in claim 11, wherein the mask insulating layer has an etch selectivity with respect to the inner spacer layer.

13. The method as claimed in claim 11 or 12, wherein the mask insulating layer is spaced apart from the first semiconductor pattern.

14. The method as claimed in claim 11, 12, or 13, wherein a thickness of the mask insulating layer, which is measured on a first source/drain pattern in a horizontal direction, is larger than a thickness measured on the first semiconductor pattern in a vertical direction.

15. The method as claimed in any one of claims 11 to 14, wherein an etching of the inner spacer layer exposes a top surface of the first semiconductor pattern.
